# EUROPEAN PATENT SPECIFICATION

(11) **EP 2 333 862 B1**
(45) Date of publication and mention of the grant of the patent: **17.09.2014**
(21) Application number: 10750935.8
(22) Date of filing: 12.03.2010
(51) Int. Cl.: H01L 51/50, C09K 11/06, H05B 33/10, H01L 51/00

(54) **PROCESS FOR MANUFACTURING ORGANIC ELECTROLUMINESCENT ELEMENT**
VERFAHREN ZUR HERSTELLUNG EINES ORGANISCHEN ELEKTROLUMINESZENTEN ELEMENTS
PROCEDE DE FABRICATION D'UN ELEMENT ORGANIQUE ELECTROLUMINESCENT

(30) Priority: 13.03.2009 JP 2009061668
(43) Date of publication of application: 15.06.2011
(73) Proprietor: Mitsubishi Chemical Corporation, Chiyoda-ku Tokyo 100-8251 (JP)
(72) Inventor: OKABE Kazuki, Yokohama-shi Kanagawa 227-8502 (JP)
(74) Representative: Vossius & Partner
(86) International application number: PCT/JP2010/054263
(87) International publication number: WO 2010/104184

(56) References cited:
- EP-A1- 1 933 401
- WO-A1-2007/074339
- WO-A1-2008/108430
- WO-A2-2007/095118
- JP-A- 2003 282 261
- JP-A- 2004 224 766
- JP-A- 2005 070 740
- JP-A- 2008 159 309
- JP-A- 2008 198 518
- TADA K ET AL: "Patterned emission from polymeric light-emitting device realized by photo-irradiation in air", THIN SOLID FILMS, ELSEVIER-SEQUOIA S.A. LAUSANNE, CH, vol. 363, no. 1-2, 1 March 2000 (2000-03-01), pages 195-197, XP004189303, ISSN: 0040-6090, DOI: 10.1016/S0040-6090(99)00999-2

## Description

### Technical Field

The present invention relates to a process for producing an organic electroluminescence element.

### Background Art

In recent years, organic electroluminescent (organic EL) elements are being developed enthusiastically as a technique for producing light-emitting devices for displays, illuminators, and the like, and have come to be practically used mainly in display applications mostly ranging from small- to medium-size displays. In the organic EL elements, positive and negative charges (carriers) are injected into organic thin films sandwiched between electrodes and the carriers are recombined to thereby obtain luminescence.

The organic EL elements that are in practical use at present are generally produced using a technique in which a compound having a relatively low molecular weight is heated under high-vacuum conditions to vapor-deposit a film on a substrate disposed above. However, this vacuum deposition method is unsuitable for the production of large displays or surface-emitting lightings having a large area because deposition of a homogeneous film on a substrate having a large area is difficult in the method. The vacuum deposition method further has a problem that the efficiency of utilization of organic materials as deposition sources is low and the production cost is apt to be high. Meanwhile, processes for producing an organic EL panel by wet film formation methods represented by spin coating, ink-jet printing, dip coating, various printing techniques, and the like have been proposed as techniques for producing those organic EL panels having a large area.

For example, patent document 1 discloses production of a blue fluorescent element including a luminescent layer formed by a wet film formation from a composition containing an anthracene derivative and an arylamine compound. However, element characteristics thereof including working life are required to be improved.

### Prior-Art Document

### Patent Document

Patent Document 1: JP-A-2004-224766

### Summary of the Invention

### Problems that the Invention is to Solve

A subject of this invention is to provide a process for producing an organic electroluminescence element which has a luminescent layer containing an arylamine compound and formed by a wet film formation method and which has a high luminance and a long working life.

### Means for Solving the Problems

The present inventors diligently made investigations. As a result, the inventors have found that the problems described above are overcome by conducting drying in a specific environment when a luminescent layer containing an arylamine compound is formed by a wet film formation method. The invention has been thus achieved.

The invention resides in a process for producing an organic electroluminescence element comprising a first electrode, a second electrode formed so as to be opposed to the first electrode, and a luminescent layer disposed between the first electrode and the second electrode, wherein the luminescent layer is a layer comprising an arylamine compound, and the luminescent layer is formed by a wet film formation in an environment shielded from light having a wavelength shorter than 500 nm.

Hereinafter, the environment shielded from light having a wavelength shorter than 500 nm is often referred to as "yellow environment".

### Effects of the Invention

According to the invention, the organic electroluminescence element, which has a luminescent layer containing an arylamine compound and formed by a wet film formation method, has a high luminescence and a long working life.

According to the invention, it is also possible to produce an organic electroluminescence element which has a luminescent layer containing an arylamine compound and formed by a wet film formation method and which has a high luminance and a long working life.

### Brief Description of the Drawings

[Fig. 1] Fig. 1 is a sectional view diagrammatically illustrating an example of the structure of an organic electroluminescence element.
[Fig. 2] Fig. 2 is a sectional view diagrammatically illustrating the structure of the test elements produced in Reference Examples 1 to 4.
[Fig. 3] Fig. 3 is a spectrum showing the photo-environment in which a luminescent layer was formed in Reference Examples 1, 3, 5, and 7 and Examples 1 to 5.
[F1ig. 4] Fig. 4 is a spectrum showing the photo-environment in which a luminescent layer was formed in Reference Examples 2, 4, 6, and 8 and Comparative Examples 1 to 5.

### Modes for Carrying Out the Invention

The organic electroluminescence element fabricated by the method of the invention is an organic electroluminescence element including a first electrode, a second electrode formed so as to face the first electrode, and a luminescent layer disposed between the first electrode and the second electrode, and is characterized in that the luminescent layer is a layer containing an arylamine compound, and the luminescent layer was formed by a wet film formation in an environment shielded from light having a wavelength shorter than 500 nm.

### <Luminescent Layer>

The luminescent layer is explained below, but the invention is not limited to the following explanations.

### [Arylamine Compound]

The luminescent layer in the invention is a layer containing an arylamine compound.

It is preferred that the arylamine compound should be a compound represented by the following general formula (1).

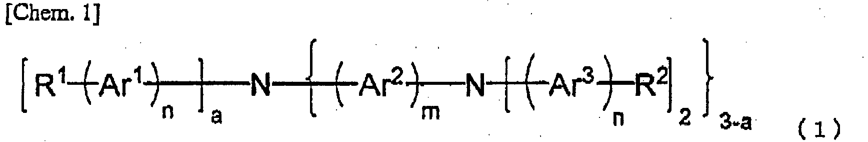

(In the formula,
Ar¹ to Ar³ each independently represent an aromatic ring which has 6-30 carbon atoms and may have a substituent, and
R¹ and R² each independently represent a hydrogen atom or an aromatic ring which has 5-30 carbon atoms and may have a substituent.)
R¹ and R² may have a crosslinkable group as a substituent possessed by the aromatic rings.
Symbols n and m each independently represent an integer of 1-3, and symbol a represents an integer of 0-3.)

Ar¹ to Ar³ each independently represent an aromatic ring group which has 6-30 carbon atoms and may have a substituent.

Examples of the aromatic ring having 6-30 carbon atoms include aromatic hydrocarbon groups and aromatic heterocyclic groups.

Examples of the aromatic hydrocarbon groups which may have a substituent include groups derived from a six-membered monocycle or a di- to pentacyclic fused ring, such as a benzene ring, naphthalene ring, anthracene ring, phenanthrene ring, perylene ring, tetracene ring, pyrene ring, benzpyrene ring, chrysene ring, triphenylene ring, acenaphthene ring, fluoranthene ring, or fluorene ring,

Examples of the aromatic heterocyclic groups which may have a substituent include groups derived from a five- or six-membered monocycle or a di- to tetracyclic fused ring, such as a furan ring, benzofuran ring, thiophene ring, benzothiophene ring, pyrrole ring, pyrazole ring, imidazole ring, oxadiazole ring, indole ring, carbazole ring, pyrroloimidazole ring, pyrrolopyrazole ring, pyrrolopyrrole ring, thienopyrrole ring, thienothiophene ring, furopyrrole ring, furofuran ring, thienofuran ring, benzisoxazole ring, benzisothiazole ring, benzimidazole ring, pyridine ring, pyrazine ring, pyridazine ring, pyrimidine ring, triazine ring, quinoline ring, isoquinoline ring, cinnoline ring, quinoxaline ring, phenanthridine ring, benzimidazole ring, perimidine ring, quinazoline ring, quinazolinone ring, or azulene ring.

Examples of the substituents which may be possessed by the aromatic ring groups represented by Ar¹ to Ar³ include the substituents shown under {Substituents Z} below.

### {Substituents Z}

Alkyl groups having preferably 1-24 carbon atoms, more preferably 1-12 carbon atoms, such as methyl and ethyl;
alkenyl groups having preferably 2-24 carbon atoms, more preferably 2-12 carbon atoms, such as vinyl;
alkynyl groups having preferably 2-24 carbon atoms, more preferably 2-12 carbon atoms, such as ethynyl;
alkoxy groups having preferably 1-24 carbon atoms, more preferably 1-12 carbon atoms, such as methoxy and ethoxy;
aryloxy groups having preferably 4-36 carbon atoms, more preferably 5-24 carbon atoms, such as phenoxy, naphthoxy, and pyridyloxy;
alkoxycarbonyl groups having preferably 2-24 carbon atoms, more preferably 2-12 carbon atoms, such as methoxycarbonyl and ethoxycarbonyl;
dialkylamino groups having preferably 2-24 carbon atoms, more preferably 2-12 carbon atoms, such as dimethylamino and diethylamino;
diarylamino groups having preferably 10-36 carbon atoms, more preferably 12-24 carbon atoms, such as diphenylamino, ditolylamino, and N-carbazolyl;
arylalkylamino groups having preferably 6-36 carbon atoms, more preferably 7-24 carbon atoms, such as phenylmethylamino;
acyl groups having preferably 2-24 carbon atoms, more preferably 2-12 carbon atoms, such as acetyl and benzoyl;
halogen atoms such as a fluorine atom and a chlorine atom;
haloalkyl groups having preferably 1-12 carbon atoms, more preferably 1-6 carbon atoms, such as trifluoromethyl;
alkylthio groups having preferably 1-24 carbon atoms, more preferably 1-12 carbon atoms, such as methylthio and ethylthio; arylthio groups having preferably 4-36 carbon atoms, more preferably 5-24 carbon atoms, such as phenylthio, naphthylthio, and pyridylthio; - silyl groups having preferably 2-36 carbon atoms, more preferably 3-24 carbon atoms, such as trimethylsilyl and triphenylsilyl;
siloxy groups having preferably 2-36 carbon atoms, more preferably 3-24 carbon atoms, such as trimethylsiloxy and triphenylsiloxy;
cyano;
aromatic hydrocarbon groups having preferably 6-36 carbon atoms, more preferably 6-24 carbon atoms, such as phenyl and naphthyl; and
aromatic heterocyclic groups having preferably 3-36 carbon atoms, more preferably 4-24 carbon atoms, such as thienyl and pyridyl.

Those substituents may have further substituents, examples of which include the groups shown above as examples under Substituents Z.

In formula (1), R¹ and R² each independently represent a hydrogen atom or an aromatic ring group which has 4-30 carbon atoms and may have a substituent.

Examples of the aromatic ring having 4-30 carbon atoms are the same as the rings enumerated above as examples of Ar¹ to Ar³, The substituents which may be possessed by the aromatic ring groups represented by R¹ and R² are also the same.

Furthermore, R¹and R² may have a crosslinkable group as a substituent.

The term "crosslinkable group" in the invention means a group which, upon heating and/or irradiation with actinic energy rays, reacts with the same or a different group of a nearby molecule to form a new chemical bond, The arylamine compound in which R¹ or R² has a crosslinkable group can be made to undergo a large difference in solubility in solvents through the reaction which occurs upon heating and/or irradiation with actinic energy rays (insolubilization reaction).

From the standpoint of easily attaining a decrease in solubility in solvents, examples of the crosslinkable group include the groups shown under {Crosslinkable Groups T} below.

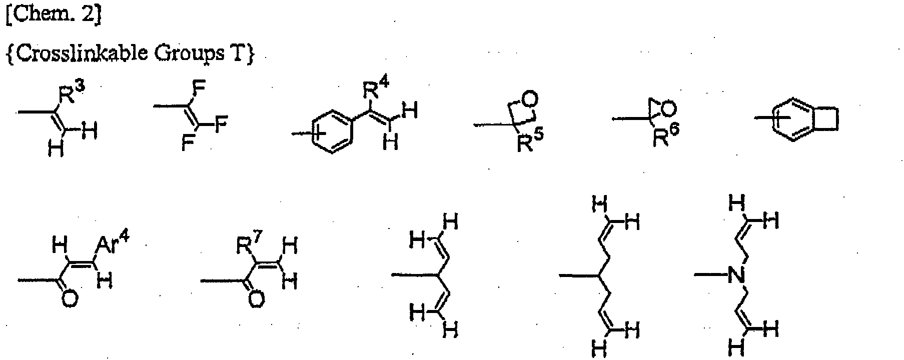

(In the formulae, R³ to R⁷ each independently represent a hydrogen atom or an alkyl group. Ar⁴ represents an aromatic hydrocarbon group which may have a substituent or an aromatic heterocyclic group which may have a substituent.)

Groups which undergo an insolubilization reaction through cationic polymerization, such as cyclic ether groups, e.g., an epoxy group and an oxetane group, and a vinyl ether group, are preferred from the standpoint that these groups have high reactivity and insolubilization therewith is easy. Of these, an oxetane group is especially preferred from the standpoint that the rate of cationic polymerization is easy to control, and a vinyl ether group is preferred from the standpoint that hydroxyl groups, which are causative of element deterioration, are less apt to generate during cationic polymerization.

Groups which undergo a cyclization addition reaction, such as arylvinylcarbonyl groups, e.g., cinnamoyl, and groups derived from a benzocyclobutene ring, are preferred from the standpoint of further improving electrochemical stability.

Furthermore, groups derived from a benzocyclobutene ring are especially preferred of those crosslinkable groups from the standpoint that the structure obtained through insolubilization therewith is especially stable.

Specifically, it is preferred that the crosslinkable group should be a group represented by the following formula (T1).

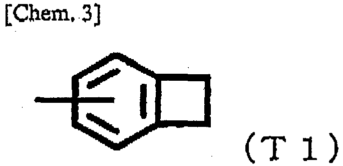

(The benzocyclobutene ring in formula (T1) may have substituents. The substituents may be bonded to each other to form a ring.)

Although the crosslinkable group may be directly bonded to the aromatic hydrocarbon group or aromatic heterocyclic group within the molecule, the crosslinkable group may be bonded through a divalent group. This divalent group preferably is a divalent group which is composed of 1 to 30 units selected from -O-, -C(=O)-, and (optionally substituted) -CH₂- groups and linked together in any desired order. It is preferred that the crosslinkable group should be bonded to the aromatic hydrocarbon group or aromatic heterocyclic group through this divalent group.

Symbols n and m represent an integer of 1-3.

Symbol a represents an integer of 0-3. In particular, when a is 2, an arylamine compound represented by the following formula (2) is preferred. When a is 3, an arylamine compound represented by the following formula (3) is preferred.

In the case where a is 2, an N,N,N',N'-tetraarylatylenediamine compound represented by the following formula (2) is preferred of the arylamine compounds represented by formula (1), especially from the standpoint that this compound has excellent durability.

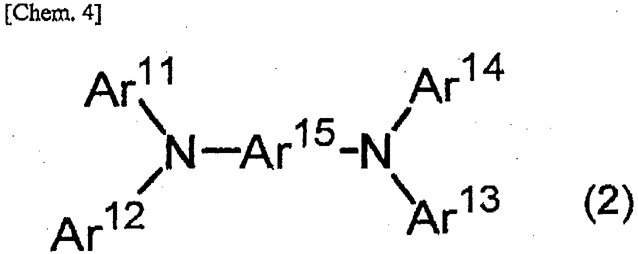

(In formula (2), Ar¹¹ to Ar¹⁵ each independently represent an aromatic hydrocarbon group which may have a substituent.)

Examples of the aromatic hydrocarbon groups represented by Ar¹¹ to Ar¹⁵ include groups derived from a benzene ring or a fused ring formed by the fusion of 2-5 benzene rings, such as a benzene ring, naphthalene ring, phenanthrene ring, anthracene ring, pyrene ring, chrysene ring, naphthacene ring, and benzophenanthrene ring.

It is preferred that Ar¹⁵ should be a group derived from a chrysene ring, among those rings, from the standpoint of attaining a high current efficiency. In particular, it is preferred that the arylamine compound should be a compound represented by the following formula (2').

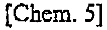

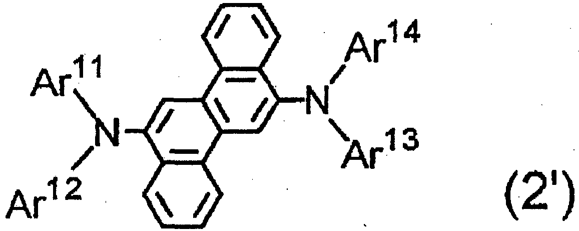

(In formula (2'), Ar¹¹ to Ar¹⁴ each independently represent an aromatic hydrocarbon group which may have a substituent.)

Ar¹¹ to Ar¹⁴ each independently represent an aromatic hydrocarbon group which may have a substituent. Examples of the aromatic hydrocarbon groups represented by Ar¹¹ to Ar¹⁴ include groups derived from a benzene ring or a fused ring formed by the fusion of 2-5 benzene rings, such as a benzene ring, naphthalene ring, phenanthrene ring, anthracene ring, pyrene ring, chrysene ring, naphthacene ring, and benzophenanthrene ring. Phenyl is preferred especially from the standpoint of obtaining blue luminescence.

The substituents which may be possessed by the aromatic hydrocarbon groups represented by Ar¹¹ to Ar¹⁴ preferably are alkyl groups, alkenyl groups, alkoxy groups, aromatic hydrocarbon groups, aromatic heterocyclic groups, or the like. In particular, alkyl groups which are oleophilic substituents are preferred.

It is preferred that the substituents should have a molecular weight of generally about 400 or lower, especially about 250 or lower.

In the case where Ar¹¹ to Ar¹⁴ have a substituent, it is preferred that the position of the substituent should be para or meta to the nitrogen atom. It is especially preferred that the position thereof should be para.

Preferred examples of the compound represented by formula (2') are shown, but the invention should not be construed as being limited to the examples,

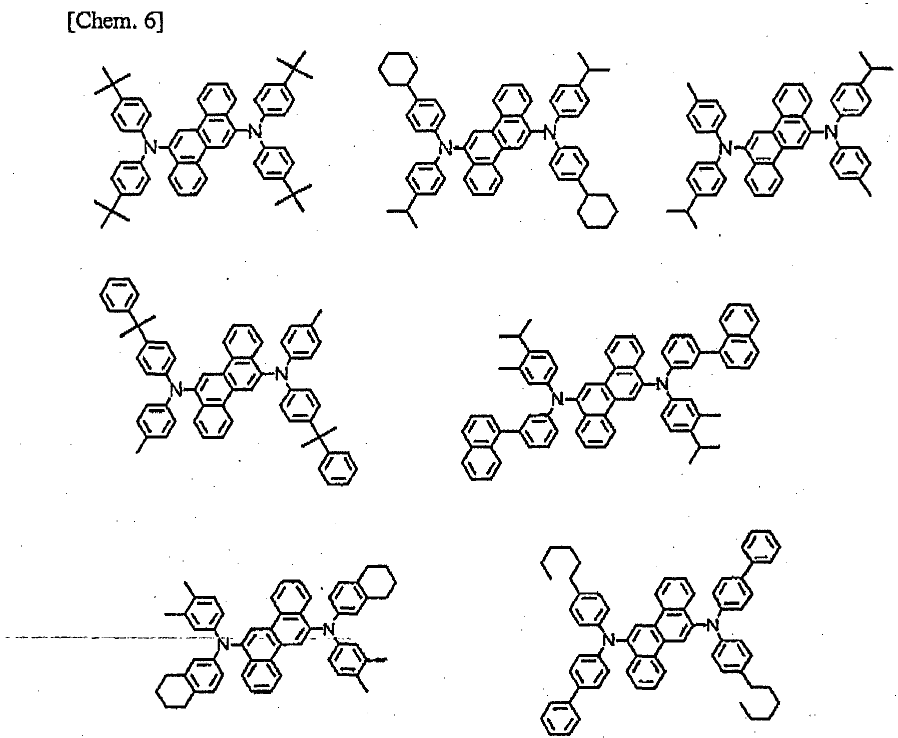

Meanwhile, in the case where symbol a is 3, an arylamine compound represented by the following formula (3) is preferred of the arylamine compounds represented by formula (1), especially from the standpoint that this compound has excellent charge-transporting ability.

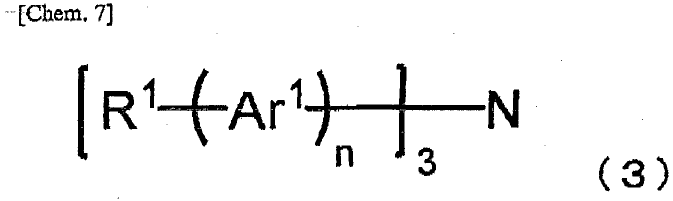

### (In the formula, n, Ar¹, and R¹ are the same as in formula (1).)

Preferred examples of the arylamine compound represented by formula (3) which is to be used especially as a charge transport material (host) are shown, but the arylamine compound should not be construed as being limited to the examples.

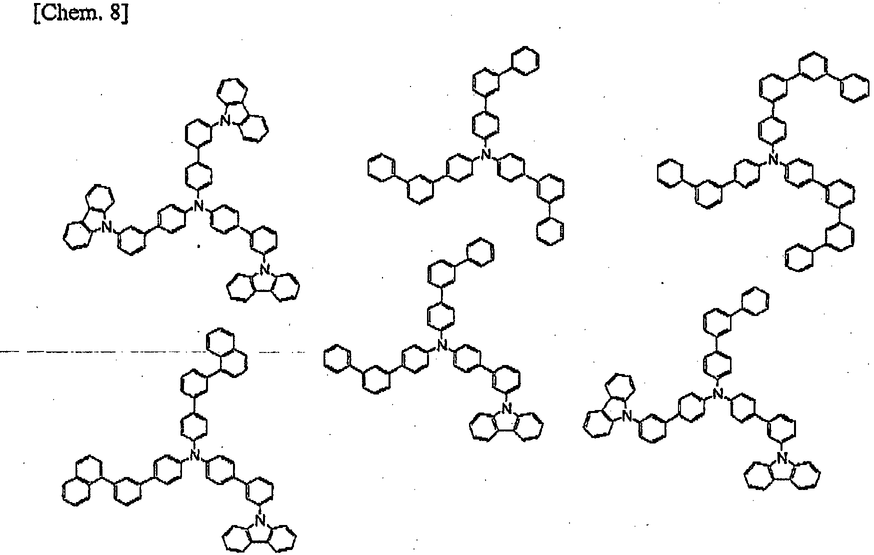

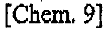

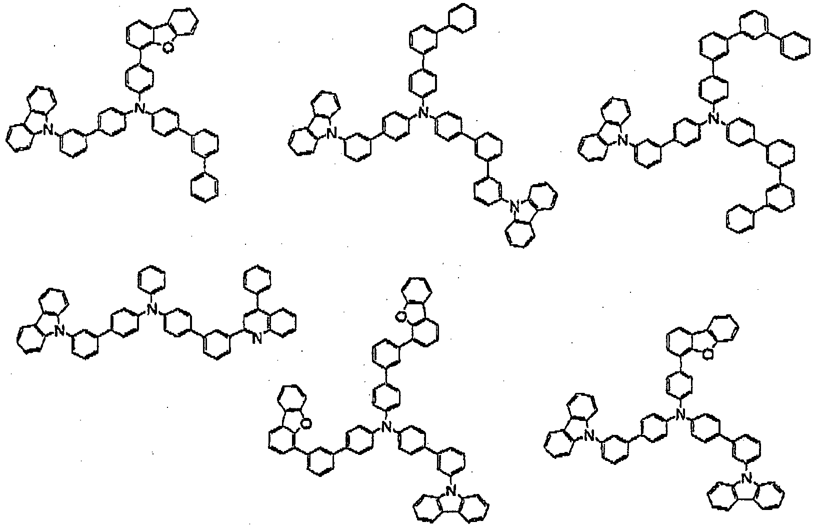

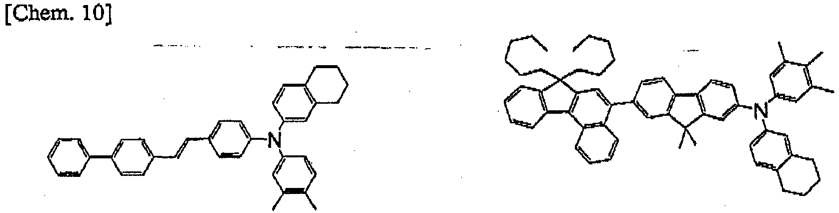

The arylamine compound may have any desired molecular weight unless the effects of the invention are considerably lessened thereby. However, the molecular weight thereof is generally 10,000 or lower, preferably 5,000 or lower, more preferably 4,000 or lower, even more preferably 3,000 or lower, and is generally 100 or higher, preferably 200 or higher, more preferably 300 or higher, even more preferably 400 or higher. When the molecular weight of the arylamine compound is too low, there are cases where this arylamine compound has considerably reduced heat resistance or is causative of gas generation or use of this arylamine compound in film formation results in reduced film quality. There also are cases where the organic electroluminescence element suffers a morphological change due to migration, etc. On the other hand, in case where the molecular weight of the arylamine compound is too high, there is a tendency that the arylamine compound is difficult to purify or dissolution of the compound in a solvent necessitates a prolonged time period. Of such arylamine compounds, low-molecular compounds are preferable to high-molecular compounds because the low-molecular compounds are more effective in enhancing the effects of the invention. The reasons for this are thought to be as follows. The composition containing a low-molecular compound has a lower viscosity than the composition containing a high-molecular compound. Because of this, when radical cations have generated during wet film formation from the composition containing a low-molecular compound, an impurity capable of serving as counter anions for the radical cations is apt to be incorporated and to diffuse. Consequently, the composition containing a low-molecular compound, when used in the configuration of the invention, is presumed to bring about higher effects.

### [Luminescent Materials]

Although the organic electroluminescence element of the invention has an arylamine compound contained in the luminescent layer, the element may contain other luminescent materials unless these materials lessen the effects of the invention.

Examples of the fluorescent materials among the other luminescent materials are shown below, but the fluorescent materials should not be construed as being limited to the following examples.

Examples of fluorescent materials which give blue luminescence (blue fluorescent materials) include naphthalene, perylene, pyrene, coumarin, p-bis(2-phenylethenyl)benzene, and derivatives of these.

Examples of fluorescent materials which give green luminescence (green fluorescent materials) include quinacridone derivatives, coumarin derivatives, and aluminum complexes such as Al(C₉H₆NO)₃.

Examples of fluorescent materials which give yellow luminescence (yellow fluorescent materials) include rubrene and perimidone derivatives.

Examples of fluorescent materials which give red luminescence (red fluorescent materials) include DCM (4-(dicyanomethylene)-2-methyl-6-(p-dimethylaminostyryl)-4H-pyran) type compounds, benzopyran derivatives, Rhodamine derivatives, benzothioxanthene derivatives, and azabenzothioxanthene.

Examples of phosphorescent materials include organometallic complexes containing a metal selected from Groups 7 to 11 of the long-form periodic table (hereinafter, the term "periodic table" means the long-form periodic table unless otherwise indicated).

Preferred examples of the metal selected from Groups 7 to 11 of the periodic table include ruthenium, rhodium, palladium, silver, rhenium, osmium, iridium, platinum, and gold.

Preferred ligands of the complexes are ligands including a (hetero)aryl group and, linked thereto, pyridine, pyrazole, phenanthroline, or the like, such as a heteroarylpyridine ligand and a (hetero)arylpyrazole ligand. Especially preferred are a phenylpyridine ligand and a phenylpyrazole ligand. The term (hereto)aryl herein means an aryl group or a heteroaryl group.

Specific examples of the phosphorescent materials include tris(2-phenylpyridine)iridium, tris(2-phenylpyridine)ruthenium, tris(2-phenylpyridine)palladium, bis(2-phenylpyridine)platinum, tris(2-phenylpyridine)osmium, tris(2-phenylpyridine)rhenium, octaethylplatinum porphyrin, octaphenylplalinum porphyrin, octaethylpalladium porphyrin, and octaphenylpalladium porphyrin.

The molecular weights of the compounds to be used as luminescent materials are the same as described above in the section [Arylamine Compound]. Preferred embodiments also are the same.

One of the luminescent materials described above may be used alone, or two or more thereof may be used in any desired combination and proportion.

### [Charge Transport Material]

The luminescent layer in the invention may further contain a charge transport material.

The charge transport material in the invention is a compound having charge-transporting properties such as hole-transporting properties or electron-transporting properties.

The charge transport material may include an arylamine compound represented by formula (1).

In the invention, one charge transport material may be used alone, or two or more charge transport materials may be used in any desired combination and proportion.

It is preferred that in the luminescent layer, a luminescent low-molecular compound should be used as a dopant material and a charge transport material be used as a host material.

The charge transport material may be a compound which has conventionally been used in the luminescent layers of organic electroluminescence elements. Especially preferred is a compound which is used as a host material for luminescent layers.

Examples of the charge transport material include aromatic amine compounds, phthalocyanine compounds, porphyrin compounds, oligothiophene compounds, polythiophene compounds, benzylphenyl compounds, a compound including tertiary amines linked with a fluorene group, hydrazone compounds, silazane compounds, silanamine compounds, phosphamine compounds, quinacridone compounds, anthracene compounds, pyrene compounds, carbazole compounds, pyridine compounds, phenanthroline compounds, oxadiazole compounds, and silole compounds.

Specific examples thereof include aromatic diamines which contain two or more tertiary amines and in which the nitrogen atoms have two or more fused aromatic rings bonded thereto as substituents, the aromatic diamines being represented by 4,4'-bis[N-(1-naphthyl)-N-phenylamino]biphenyl (JP-A-5-234681), aromatic amine compounds having a starburst structure, such as 4,4',4"-tris(1-naphthylphenylamino)triphenylamine (J. Lumin., Vol.72-74, p.985, 1997), the aromatic amine compound constituted of the tetramer of triphenylamine (Chem. Commun., p.2175, 1996), fluorene compounds such as 2,2',7,7'-tetrakis(diphenylamino)-9,9'-spirobifluorene (Synth. Metals, Vol.91, p.209, 1997), carbazole compounds such as 4,4'-N,N'-dicarbazolylbiphenyl, oxadiazole compounds such as 2-(4-biphenylyl)-5-(p-tert-butylphenyl)-1,3,4-oxadiazole (tBu-PBD) and 2,5-bis(1-naphthyl)-1,3,4-oxadiazole (BND), silole compounds such as 2,5-bis(6'-(2',2"-bipyridyl))-1,1-dimethyl-3,4-diphenylsilole (PyPySPyPy), and phenanthroline compounds such as bathophenanthroline (BPhen) and 2,9-dimethyl-4,7-diphenyl-1,10-phenanthroline (BCP; bathocuproine).

### [Composition for Luminescent Layer]

The luminescent layer in the invention is formed by a wet film formation method. For forming the luminescent layer by a wet film formation method, use is made of a composition for film formation (composition for luminescent-layer formation) prepared by mixing the arylamine compound for constituting the luminescent layer with a suitable solvent optionally together with other ingredients.

### {Solvent}

The solvent is not particularly limited so long as the luminescent material and the charge transport material satisfactorily dissolve therein_{.}

With respect to solubility in the solvent, it is preferred that the luminescent material and the charge transport material each can dissolve therein in an amount of generally 0.01% by weight or more, preferably 0.05% by weight or more, more preferably 0.1% by weight or more, at ordinary temperature and ordinary pressure.

Examples of the solvent are shown below, but the solvent should not be construed as being limited to the examples unless the effects of the invention are lessened.

Examples thereof include alkanes such as n-decane, cyclohexane, ethylcyclohexane, decalin, and bicyclohexane; aromatic hydrocarbons such as toluene, xylene, mesitylene, cyclohexylbenzene, and tetralin; halogenated aromatic hydrocarbons such as chlorobenzene, dichlorobenzene, and trichlorobenzene; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, 2,4-dimethylanisole, and diphenyl ether; aromatic esters such as phenyl acetate, phenyl propionate, methyl benzoate, ethyl benzoate, propyl benzoate, and n-butyl benzoate; alicyclic ketones such as cyclohexanone, cyclooctanone, and fenchone; alicyclic alcohols such as cyclohexanol and cyclooctanol; aliphatic ketones such as methyl ethyl ketone and dibutyl ketone; aliphatic alcohols such as butanol and hexanol; and aliphatic ethers such as ethylene glycol dimethyl ether, ethylene glycol diethyl ether, and propylene glycol 1-monomethyl ether acetate (PGMEA).

Of these, the halogen-free solvents are preferable to the halogenated solvents. Halogenated solvents, in particular, chlorinated solvents, are apt to decompose in the presence of light or oxygen and, hence, may serve as counter anions when the arylamine compound forms radical cations. The halogenated solvents are therefore undesirable.

More preferred of the halogen-free solvents are the alkanes and the aromatic hydrocarbons. One of these solvents may be used alone, or two or more thereof may be used in any desired combination and proportion.

From the standpoint of obtaining a more even film, it is preferred that the solvent should vaporize at an appropriate rate from the liquid film immediately after formation of the liquid film. In order for the solvent to satisfy this, the boiling point of the solvent is generally 80°C or higher, preferably 100°C or higher, more preferably 120°C or higher, and is generally 270°C or lower, preferably 250°C or lower, more preferably 230°C or lower.

The amount of the solvent to be used is not limited unless the effects of the invention are considerably lessened. However, the amount thereof per 100 parts by weight of the composition for luminescent-layer formation is preferably 10 parts by weight or more, more preferably 50 parts by weight or more, especially preferably 80 parts by weight or more, and is preferably 99.95 parts by weight or less, more preferably 99.9 parts by weight or less, especially preferably 99.8 parts by weight or less. In case where the content thereof is less than the lower limit, there is a possibility that the composition might have too high viscosity and have reduced applicability in film formation. On the other hand, in case where the content thereof exceeds the upper limit, the film obtained by applying the composition and then removing the solvent therefrom cannot have a desired thickness and there is hence a tendency that film formation is difficult. In the case where a mixture of two or more solvents is used in the composition for luminescent-layer formation, these solvents are incorporated so that the sum of these satisfies that range.

The composition for luminescent-layer formation in the invention may contain various additives such as a leveling agent and an antifoamer so as to have improved film-forming properties.

### [Method of Forming Luminescent Layer]

The luminescent layer in the invention is formed by a wet film formation method.

The composition for luminescent-layer formation, which is for producing the luminescent layer, is applied, and the resultant coating film is dried to remove the solvent for luminescent-layer formation. Thus, a luminescent layer is formed.

In the invention, the wet film formation is conducted in a yellow environment It is preferred that the drying after the wet film formation should also be conducted in a yellow environment.

The term "wet film formation, method" in the invention means a method in which a film is formed by a wet film formation, such as, for example, spin coating, dip coating, die coating, bar coating, blade coating, roll coating, spray coating, capillary coating, ink-jet printing, screen printing, gravure printing, or flexographic printing. Preferred of these film formation methods are spin coating, spray coating, and ink-jet printing. This is because these techniques suit with the liquid nature of the composition for wet film formation to be used for producing the organic electroluminescence element.

### {Drying}

In producing the organic electroluminescence element of the invention, drying is preferably conducted in a yellow environment after the luminescent layer has been applied by the wet film formation method. Namely, it is preferred that the composition should be dried in an environment shielded from light having a wavelength shorter than 500 nm.

In this environment, a radical-cationization of the arylamine compound due to the light having a short wavelength is inhibited. The drying is hence preferred from the standpoint that the element obtained has a high luminance and a long working life.

Light having a wavelength shorter than 500 nm can be detected, for example, by examining the light source with photonic multichannel analyzer C7473 (manufactured by Hamamatsu Photonics K.K.) for spectrum. Through this examination, whether the environment has been shielded from the short-wavelength light can be ascertained. Although it is preferred to conduct the examination in the place where a substrate is to be disposed when wet film formation is performed, it is possible to use a substitute method in which the examination is conducted in a place which adjoins the apparatus for wet film formation, such as the place located on or at the side of the apparatus.

Incidentally, the measuring apparatus to be used for detecting light having a wavelength shorter than 500 nm in the invention is not limited to the measuring apparatus shown above, and another measuring apparatus may be used so long as the same measurement as the measurement made with that apparatus is possible. However, it is preferred to use that measuring apparatus.

For eliminating light having wavelengths shorter than 500 nm in the invention, a commercial yellow fluorescent lamp can, for example, be used. For example, a yellow fluorescent lamp manufactured by Mitsubishi Electric Osram Ltd. can be used. Furthermore, a yellow filter for fluorescent lamps can be used, and Banguard Orange Series, manufactured by Nakagawa Chemical, Inc., can, for example, be used. Moreover, a box which blocks light having wavelengths shorter than 500 nm may be disposed so as to surround the application environment.

### {Drying Methods}

Drying methods are not particularly limited unless the effects of the invention are lessened. Use can be made of methods such as heating, irradiation with an electromagnetic wave, pressure reduction, etc. It is also possible to use a suitable combination of these methods.

Examples of means for heating include a clean oven and a hot plate. Examples of the irradiation with an electromagnetic wave include irradiation with infrared rays, microwaves, or the like.

In the case where drying is conducted with a heating means, i.e., in the case where a heating step is conducted, the direction of heating in the heating step is not limited unless the effects of the invention are considerably lessened. Examples of the direction of heating include a method in which the substrate is placed on a hot plate and the coating film is heated through the hot plate to thereby heat the coating film from the lower surface of the substrate (i.e., from the surface not coated with the organic layer) and a method in which the substrate is introduced into a clean oven to thereby heat the coating film from all directions including the front, back, right-hand, and left-hand directions.

Heating temperature in the heating step is not particularly limited unless the effects of the invention are considerably lessened. However, it is preferred to heat the coating film at a temperature which is generally 90°C or higher, preferably 100°C or higher, and is generally 200°C or lower, preferably 140°C or lower. In case where the temperature is too high, there is a possibility that a component of the composition for the organic electroluminescence element of the invention might diffuse into other layers. In case where the temperature is too low, there is a possibility that the residual solvent remaining in a slight amount cannot be sufficiently removed. In the case where a mixed solvent including two or more of the solvents enumerated above is to be heated, it is preferred to heat the coating film at a temperature not lower than the boiling point of at least one solvent.

Heating period in the heating step is not limited unless the effects of the invention are considerably lessened. However, the heating period is preferably 15 minutes or longer, more preferably 30 minutes or longer, even more preferably 1 hour or longer, and is preferably 6 hours or shorter, more preferably 3 hours or shorter, even more preferably 2 hours or shorter. Thus, the coating film can be sufficiently insolubilized. In case where the heating period is too long, there is a tendency that a component of another layer diffuses into the luminescent layer. In case where the heating period is too short, the resultant luminescent-layer film does not have sufficient homogeneity.

In the case where vacuum drying is conducted, the pressure is generally 1,000 Pa or lower, preferably 500 Pa or lower, and is generally 10⁻³ Pa or higher, preferably 10⁻² Pa or higher. In case where the pressure exceeds the upper limit, there is a possibility that the residual solvent cannot be sufficiently removed because of an Insufficient vacuum. In case where the pressure is lower than the lower limit, the evacuation equipment is more costly.

The time period required for a pressure for vacuum drying to be reached depends on the vacuum-drying pressure. In case where a high degree of vacuum is reached in too short a time period, there is a possibility that the flatness of the film might be impaired by too high a drying rate.

Examples of means for heating include a clean oven, hot plate, infrared rays, halogen lamp heater, and irradiation with microwaves. Of these, a clean oven and a hot plate are preferred from the standpoint of evenly heating the whole film.

The direction of heating in the heating step is not limited unless the effects of the invention are considerably lessened. Examples of the direction of heating include a method in which the substrate is placed on a hot plate and the coating film is heated through the hot plate to thereby heat the coating film from the lower surface of the substrate (i.e., from the surface not coated with the organic layer) and a method in which the substrate is introduced into a clean oven to thereby heat the coating film from all directions including the front, back, right-hand, and left-hand directions.

Heating temperature in the heating step is not particularly limited unless the effects of the invention are considerably lessened. However, it is preferred to heat the coating film at a temperature which is generally 90°C or higher, preferably 100°C or higher, and is generally 200°C or lower, preferably 140°C or lower. In case where the temperature is too high, there is a possibility that a component of the composition for the organic electroluminescence element of the invention might diffuse into other layers. In case where the temperature is too low, there is a possibility that the residual solvent remaining in a slight amount cannot be sufficiently removed. In the case where a mixed solvent including two or more of the solvents enumerated above is to be heated, it is preferred to heat the coating film at a temperature not lower than the boiling point of at least one solvent.

Heating period in the heating step is not limited unless the effects of the invention are considerably lessened. However, the heating period is preferably 15 minutes or longer, more preferably 30 minutes or longer, even more preferably 1 hour or longer, and is preferably 6 hours or shorter, more preferably 3 hours or shorter, even more preferably 2 hours or shorter. Thus, the coating film can be sufficiently insolubilized. In case where the heating period is too long, there is a tendency that a component of another layer diffuses into the luminescent layer. In case where the heating period is too short, the resultant luminescent-layer film does not have sufficient homogeneity.

The concentration of the solid components, such as the luminescent material, hole-transporting compound, and electron-transporting compound, in the composition for luminescent-layer formation is generally 0.01% by weight or higher and is generally 70% by weight or lower. In case where the concentration thereof is too high, there is the possibility of resulting in unevenness in film thickness. In case where the concentration thereof is too low, there is the possibility of forming a film having defects.

The luminescent layer has any desired thickness unless the effects of the invention are considerably lessened. However, the thickness thereof is generally 3 nm or more, preferably 5 nm or more, and is generally 200 nm or less, preferably 100 nm or less. In case where the thickness of the luminescent layer is too small, there is a possibility that the film might have defects. In case where the thickness thereof is too large, there is the possibility of resulting in an increase in operating voltage.

### <Reasons why the Effects of the Invention are Obtained>

The reasons why the effects of the invention are obtained by forming a luminescent layer containing an arylamine compound by a wet film formation method in a yellow environment are presumed to be as follows.

The arylamine compound becomes a radical cation upon irradiation with light having a wavelength shorter than 500 nm. The light-induced conversion of the arylamine compound into a radical cation is further enhanced by the presence of heat. In case where a radical cation species is present in the luminescent layer of an element obtained, the radical cation species exerts the following and other actions when the element works, i.e., when a current flows therethrough. The radical cation species traps electrons which have flowed from the cathode side, or the radical cations interact with excitons present in the luminescent layer to thereby deactivate the excitons. As a result, the element obtained has a reduced luminance.

Namely, it is presumed that the arylamine compound is inhibited from becoming a radical cation by blocking light having wavelengths shorter than 500 nm and, as a result, excitons in the luminescent layer are prevented from being deactivated. Consequently, according to the invention, excitons which contribute to luminescence are available in a larger amount, and the luminance is improved.

### <Process for Producing Organic Electroluminescence element>

The invention provides a process for producing an organic electroluminescence element including a first electrode, a second electrode formed so as to face the first electrode, and a luminescent layer disposed between the first electrode and the second electrode, the process being characterized in that the luminescent layer is a layer containing an arylamine compound, and the luminescent layer is formed by a wet film formation in an environment shielded from light having a wavelength shorter than 500 nm.

Materials for forming the luminescent layer and the process for production are the same as described above under <Luminescent Layer>. Preferred embodiments also are the same.

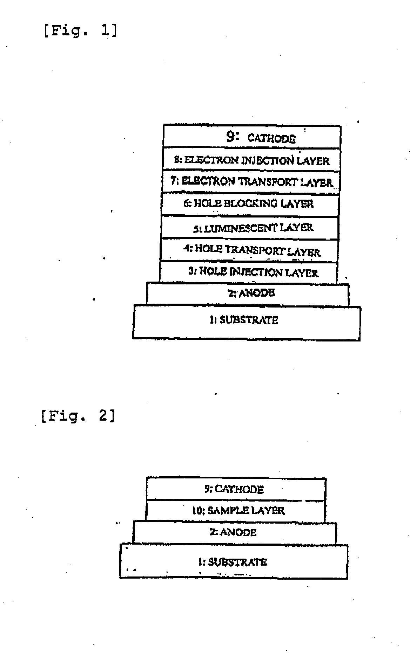

The layer configuration of an organic electroluminescence element to be produced by the process of the invention, methods for formation thereof, etc. are explained below by reference to Fig. 1.
Fig. 1 is a diagrammatic sectional view showing an example of the structure of an organic electroluminescence element according to the invention. In Fig. 1, numeral 1 denotes a substrate, 2 an anode, 3 a hole injection layer, 4 a hole transport layer, 5 a luminescent layer, 6 a hole blocking layer, 7 an electron transport layer, 8 an electron injection layer, and 9 a cathode.

In the element shown in Fig. 1, the hole transport layer corresponds to a charge transport layer.

### [Substrate]

The substrate 1 serves as the support of the organic electroluminescence element, and use may be made of a plate of quartz or glass, a metal plate, a metal foil, a plastic film or sheet, or the like. Especially preferred are a glass plate and a plate of a transparent synthetic resin such as a polyester, polymethacrylate, polycarbonate, or polysulfone. In the case of using a synthetic-resin substrate, it is necessary to take account of gas barrier properties. In case where the substrate has too low gas barrier properties, there are cases where the surrounding air might pass through the substrate to deteriorate the organic electroluminescence element. Too low gas barrier properties are hence undesirable. Consequently, one of preferred methods is to form a dense silicon oxide film on at least one surface of a synthetic-resin substrate to ensure gas barrier properties.

### [Anode]

The anode 2 has the function of injecting holes into layers located on the luminescent layer side.

This anode 2 is usually constituted of a metal, e.g., aluminum, gold, silver, nickel, palladium, or platinum, a metal oxide, e.g., an indium and/or tin oxide, a metal halide, e.g., copper iodide, carbon black, a conductive polymer, e.g., poly(3-methylthiophene), polypyrrole, or polyaniline, or the like.

Usually, the anode 2 is frequently formed by sputtering, vacuum deposition, or the like. In the case where an anode 2 is to be formed using fine particles of a metal, e.g., silver, fine particles of copper iodide or the like, carbon black, fine particles of a conductive metal oxide, fine particles of a conductive polymer, or the like, use may be made of a method in which such fine particles are dispersed in an appropriate binder resin solution and the dispersion is applied to a substrate 1 to form an anode 2. Furthermore, in the case of a conductive polymer, an anode 2 can be formed by directly forming a thin film on a substrate 1 through electrolytic polymerization or by applying the conductive polymer to a substrate 1 (Appl. Phys. Lett., Vol.60, p.2711, 1992).

The anode 2 usually has a single-layer structure. However, the anode 2 can have a multilayer structure composed of a plurality of materials, according to need.

The thickness of the anode 2 varies depending on the degree of transparency required. When transparency is required, it is preferred that the anode 2 should be regulated so as to have a visible-light transmittance of generally 60% or higher, preferably 80% or higher. In this case, the thickness of the anode 2 is generally 5 nm or more, preferably 10 nm or more, and is generally 1,000 nm or less, preferably about 500 nm or less. When the anode 2 may be opaque, this anode 2 can have any desired thickness and may be identical with the substrate 1. Furthermore, it is possible to superpose a different conductive material on the anode 2.

It is preferred that the surface of the anode 2 should be subjected to an ultraviolet (UV)/ozone treatment or a treatment with an oxygen plasma or argon plasma for the purposes of removing impurities adherent to the anode 2 and regulating ionization potential to improve hole injection properties.

### [Hole Injection Layer]

The hole injection layer 3 is a layer which transports holes from the anode 2 to the luminescent layer 5, and is usually formed on the anode 2.

Methods for forming the hole injection layer 3 according to the invention are not particularly limited, and either vacuum deposition or a wet film formation method may be used. However, from the standpoint of diminishing dark spots, it is preferred to form the hole injection layer 3 by a wet film formation method.

The thickness of the hole injection layer 3 is generally 5 nm or more, preferably 10 nm or more, and is generally 1,000 nm or less, preferably less than 500 nm.

### {Formation of Hole Injection Layer by Wet Film Formation Method}

In the case where a hole injection layer 3 is to be formed by a wet film formation, the hole injection layer 3 is formed usually by mixing materials for constituting the hole injection layer 3 with an appropriate solvent (solvent for hole injection layer) to prepare a composition for film formation (composition for hole injection layer formation), applying this composition for hole injection layer formation by a suitable technique to the layer (usually, the anode) which is to underlie the hole injection layer 3, and then drying the resultant coating film.

### (Hole-Transporting Compound)

The composition for hole injection layer formation usually contains a hole-transporting compound, as a material for constituting the hole injection layer, and a solvent

The hole-transporting compound may usually be a high-molecular compound such as a polymer or a low-molecular compound such as a monomer so long as the compound has hole-transporting properties and is for use in the hole injection layers of organic electroluminescence elements. It is, however, preferred that the hole-transporting compound should be a high-molecular compound.

From the standpoint of a barrier to charge injection from the anode 2 into the hole injection layer 3, it is preferred that the hole-transporting compound should be a compound having an ionization potential of 4.5 eV to 6.0 eV. Examples of the hole-transporting compound include arylamine compounds, phthalocyanine derivatives, porphyrin derivatives, oligothiophene derivatives, polythiophene derivatives, benzylphenyl compounds, a compound including tertiary amines linked with a fluorene group, hydrazone derivatives, silazane derivatives, silanamine derivatives, phosphamine derivatives, quinacridone derivatives, polyaniline derivatives, polypyrrole derivatives, polyphenylenevinylene derivatives, polythienylenevinylene derivatives, polyquinoline derivatives, polyquinoxaline derivatives, and carbon.

Incidentally, the term "derivative" in the invention has the following meaning. In the case of an arylamine compound, for example, that term includes the aromatic amine itself and compounds having the aromatic amine as the main framework, and these compounds may be polymers or monomers.

Any one of such hole-transporting compounds may be contained alone as a material for the hole injection layer 3, or two or more thereof may be contained as the material. In the case where two or more hole-transporting compounds are contained, any desired combination of such compounds may be used. However, it is preferred to use one or more aromatic tertiary amine high-molecular compounds in combination with one or more other hole-transporting compounds.

Of the compounds shown above as examples, aromatic amine compounds are preferred from the standpoints of noncrystallinity and visible-light transmittance. In particular, aromatic tertiary amine compounds are preferred. The term aromatic tertiary amine compound means a compound having an aromatic tertiary amine structure, and includes a compound having a group derived from an aromatic tertiary amine.

The kind of aromatic tertiary amine compound is not particularly limited. However, a high-molecular compound (polymeric compound made up of consecutive repeating units) having a weight-average molecular weight of 1,000-1,000,000 is more preferred from the standpoint of even luminescence based on the effect of surface smoothing. Preferred examples of the aromatic tertiary amine high-molecular compound include high-molecular compounds having a repeating unit represented by the following formula (I).

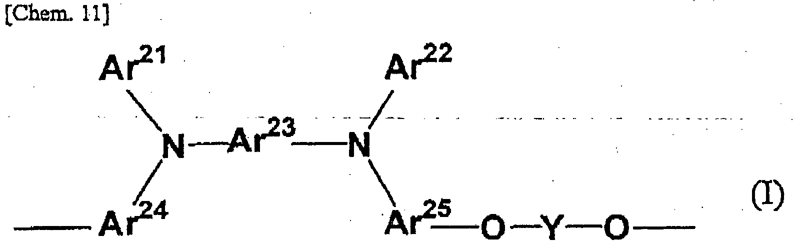

(In formula (I), Ar²¹ and Ar²² each independently represent an aromatic hydrocarbon group which may have a substituent or an aromatic heterocyclic group which may have a substituent. Ar²³ to Ar²⁵ each independently represent an aromatic hydrocarbon group which may have a substituent or an aromatic heterocyclic group which may have a substituent. Y represents a linking group selected from the following linking groups. Of Ar²¹ to Ar²⁵, two groups bonded to the same nitrogen atom may be bonded to each other to form a ring.)

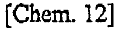

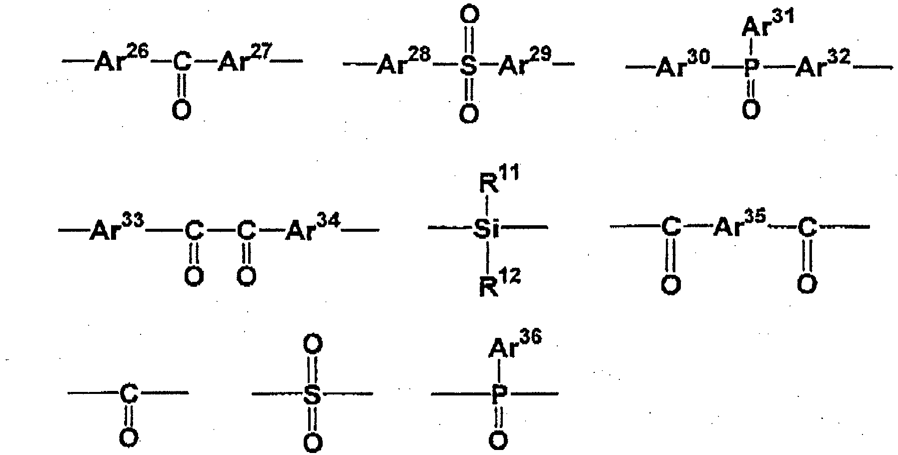

(In the formulae, Ar²⁶ to Ar³⁶ each independently represent an aromatic hydrocarbon group which may have a substituent or an aromatic heterocyclic group which may have a substituent. R¹¹ and R¹² each independently represent a hydrogen atom or any desired substituent.))

The aromatic hydrocarbon groups and aromatic heterocyclic groups represented by Ar²¹ to Ar³⁶ preferably are groups derived from a benzene ring, naphthalene ring, phenanthrene ring, thiophene ring, or pyridine ring, from the standpoints of the solubility, heat resistance, and suitability for hole injection and transport of the high-molecular compound. More preferred are groups derived from a benzene ring or a naphthalene ring.

The aromatic hydrocarbon groups and aromatic heterocyclic groups represented by Ar²¹ to Ar³⁶ may have further substituents. It is preferred that the molecular weights of the substituents should be generally about 400 or lower, in particular, about 250 or lower. Preferred examples of the substituents are alkyl groups, alkenyl groups, alkoxy groups, aromatic hydrocarbon groups, aromatic heterocyclic groups, and the like.

In the case where R¹¹ and R¹² are any desired substituents, examples of the substituents include alkyl groups, alkenyl groups, alkoxy groups, silyl group, siloxy group, aromatic hydrocarbon groups, and aromatic heterocyclic groups.

Specific examples of the aromatic tertiary amine high-molecular compounds having a repeating unit represented by formula (I) include the compounds described in International Publication No. 2005/089024.

Also preferred as a hole-transporting compound is a conductive polymer (PEDOT/PSS) obtained by polymerizing 3,4-ethylenedioxythiophene, which is a derivative of polythiophene, in high-molecular poly(styrenesulfonic acid). This polymer may have been modified by capping the ends thereof with a methacrylate or the like.

The concentration of the hole-transporting compound in the composition for hole injection layer formation is not limited unless the effects of the invention are lessened. However, from the standpoint of the evenness of film thickness, the concentration thereof is generally 0.01% by weight or higher, preferably 0.1% by weight or higher, more preferably 0.5% by weight or higher, and is generally 70% by weight or lower, preferably 60% by weight or lower, more preferably 50% by weight or lower. In case where the concentration thereof is too high, there is a possibility that unevenness of film thickness might result. In case where the concentration thereof is too low, there is a possibility that the resultant hole injection layer might have defects.

### (Electron-Accepting Compound)

It is preferred that the composition for hole injection layer formation should contain an electron-accepting compound as a constituent material for the hole injection layer.

The electron-accepting compound preferably is a compound which has oxidizing ability and has the ability to accept one electron from the hole-transporting compound described above. Specifically, compounds having an electron affinity of 4 eV or higher are preferred, and compounds having an electron affinity of 5 eV or higher are more preferred.

Examples of such electron-accepting compounds include one or more compounds selected from the group consisting of triarylboron compounds, metal halides, Lewis acids, organic acids, onium salts, salts of an arylamine with a metal halide, and salts of an arylamine with a Lewis acid. More specifically, examples thereof include onium salts substituted with organic groups, such as 4-isopropyl-4'-methyldiphenyliodonium tetrakis(pentafluorophenyl)borate and triphenylsufonium tetrafluoroborate (International Publication No. 2005/089024); inorganic compounds having a high valence, such as iron(III) chloride (JP-A-11-251067) and ammonium peroxodisulfate; cyano compounds such as tetracyanoethylene; aromatic boron compounds such as tris(pentafluorophenyl)borane (JP-A-2003-31365); fullerene derivatives; iodine; and sulfonic acid ions such as poly(styrenesulfonic acid) ions; albylbenzenesulfonic acid ions, and camphorsulfonic acid ions.

These electron-accepting compounds oxidize the hole-Transporting compound and can thereby improve the conductivity of the hole injection layer.

In the hole injection layer or in the composition for hole injection layer formation, the content of the electron-accepting compound is generally 0.1% by mole or higher, preferably 1% by mole or higher, based on the hole-transporting compound. However, the content thereof is generally 100% by mole or lower, preferably 40% by mole or lower.

### (Other Constituent Materials)

Besides the hole-transporting compound and electron-accepting compound described above, other ingredients may be incorporated as materials for the hole injection layer unless the incorporation thereof considerably lessens the effects of the invention. Examples of the other ingredients include various luminescent materials, electron-transporting compounds, binder resins, and applicability improvers. One of such other ingredients may be used alone, or two or more thereof may be used in any desired combination and proportion.

### (Solvent)

It is preferred that the solvent contained in the composition for use in hole injection layer formation by a wet film formation method should include at least one compound in which the constituent materials for the hole injection layer described above can dissolve. It is also preferred that the boiling point of the solvent should be generally 110°C or higher, preferably 140°C or higher, more preferably 200°C or higher, and be generally 400°C or lower, in particular 300°C or lower. In case where the boiling point of the solvent is too low, there is a possibility that the composition might dry at too high a rate, resulting in impaired film quality. In case where the boiling point of the solvent is too high, it is necessary to use a higher temperature in the drying step and this may adversely affect other layers or the substrate.

Examples of the solvent include ether solvents, ester solvents, aromatic hydrocarbon solvents, and amide solvents.

Examples of the ether solvents include aliphatic ethers such as ethylene glycol dimethyl ether, ethylene glycol diethyl ether, and propylene glycol 1-monomethyl ether acetate (PGMEA); and aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, and 2,4-dimethylanisole.

Examples of the ester solvents include aromatic esters such as phenyl acetate, phenyl propionate, methyl benzoate, ethyl benzoate, propyl bsnzoate, and n-butyl benzoate.

Examples of the aromatic hydrocarbon solvents include toluene, xylene, cyclohexylbenzene, 3-isopropylbiphenyl, 1,2,3,4-tetramethylbenzene, 1,4-diisopropylbenzene, cyclohexylbenzene, and methylnaphthalene, Examples of the amide solvents include N,N-dimethylformamide and N,N-dimethylacetamide.

Furthermore, dimethyl sulfoxide and the like are also usable.

One of these solvents may be used alone, or two or more thereof may be used in any desired combination and proportion.

### (Methods of Film Formation)

After the composition for hole injection layer formation has been prepared, this composition is applied, by a wet film formation, to the layer (usually, the anode 2) which is to underlie the hole injection layer 3, and the resultant coating film is dried. Thus, a hole injection layer 3 is formed.

The temperature to be used in the film formation step is preferably 10°C or higher and is preferably 50°C or lower, from the standpoint of preventing crystals from generating in the composition and thereby causing film defects.

The relative humidity in the film formation step is not limited unless the effects of the invention are considerably lessened. However, the relative humidity is generally 0.01 ppm or higher and is generally 80% or less.

After the film formation, the film of the composition for hole injection layer formation is dried usually by heating, etc. Examples of means for heating usable in the heating step include a clean oven, hot plate, infrared rays, halogen lamp heater, and irradiation with microwaves. Of these, a clean oven and a hot plate are preferred from the standpoint of evenly heating the whole film.

With respect to heating temperature in the heating step, it is preferred to heat the film at a temperature not lower than the boiling point of the solvent used in the composition for hole injection layer formation, unless this drying considerably lessens the effects of the invention. In the case where the solvent used for hole injection layer formation is a mixed solvent including two or more solvents, it is preferred to heat the film at a temperature not lower than the boiling point of at least one of the solvents. When an increase in the boiling point of solvents is taken into account, it is preferred to heat the film in the heating step at a temperature which is preferably 120°C or higher and is preferably 410°C or lower.

Heating period in the heating step is not limited so long as the heating temperature is not lower than the boiling point of the solvent of the composition for hole injection layer formation and the coating film is not sufficiently insolubilized. However, the heating period is preferably 10 seconds or longer, and is generally 180 minutes or shorter. In case where the heating period is too long, components of other layers tend to diffuse. In case where the heating period is too short, the resultant hole injection layer tends to be inhomogeneous. Heating may be conducted two times.

### {Formation of Hole Injection Layer by Vacuum Deposition}

In the case where a hole injection layer 3 is to be formed by vacuum deposition, one or more constituent materials (e.g., the hole-transporting compound and electron-accepting compound described above) for the hole injection layer 3 are placed in one or more crucibles disposed within a vacuum vessel (when two or more materials are used, the materials are placed in respective crucibles). The inside of the vacuum vessel is evacuated with an appropriate vacuum pump to about 10⁻⁴ Pa, and the crucibles are then heated (when two or more materials are used, the respective crucibles are heated) to vaporize the materials while controlling vaporization amount (when two or more materials are used, the materials are vaporized while independently controlling the amounts of the materials being vaporized) to form a hole injection layer 3 on the anode 2 of a substrate placed so as to face the crucibles. Incidentally, in the case where two or more materials are used, use may be made of a method in which a mixture of these materials is placed in a crucible, heated, and vaporized to form a hole injection layer 3.

The degree of vacuum during the deposition is not limited unless the effects of the invention are considerably lessened. However, the degree of vacuum is generally 0.1×10⁻⁶ Torr (0.13×10⁻⁴ Pa) or higher, and is generally 9.0×10⁻⁶ Torr (12.0×10⁻⁴ Pa) or lower. The rate of deposition is not limited unless the effects of the invention are considerably lessened. However, the rate of deposition is generally 0.1 Å/sec or higher, and is generally 5.0 Å/sec or lower. Film formation temperature during the deposition is not limited unless the effects of the invention are considerably lessened. However, the deposition is conducted at a temperature which is preferably 10°C or higher and is preferably 50°C or lower.

### [Hole Transport Layer]

The term "hole transport layer" in the invention means the layer which adjoins the luminescent layer on the anode side thereof. Methods for forming the hole transport layer 4 according to the invention are not particularly limited, and either vacuum deposition or a wet film formation method may be used. However, from the standpoint of diminishing dark spots, it is preferred to form the hole transport layer 4 by a wet film formation method.

In the case where there is a hole injection layer, a hole transport layer 4 can be formed on the hole injection layer 3. When there is no hole injection layer 3, then a hole transport layer 4 can be formed on the anode 2. The organic electroluminescence element of the invention may have a configuration in which the hole transport layer has been omitted.

For forming the hole transport layer 4, it is preferred to use a material which has high hole-transporting properties and can efficiently transport injected holes. In order for a material to have such properties, it is preferred that the material should have a low ionization potential, be highly transparent to visible light, and have a high hole mobility and excellent stability, and that impurities functioning as a trap do not generate during production of the material or during use. Furthermore, since the hole transport layer 4 is in contact with the luminescent layer 5 in many cases, it is preferred that the material constituting the hole transport layer 4 should not function to cause extinction of luminescence from the luminescent layer 5 or to form an exciplex with the luminescent layer 5 and thereby reduce efficiency.

As such a material for the hole transport layer 4, use may be made of materials which have conventionally been used as constituent materials for hole transport layers. Examples thereof include the materials enumerated above as examples of the hole-transporting compound to be used in the hole injection layer 3 described above. Examples thereof further include arylamine derivatives, fluorene derivatives, spiro derivatives, carbazole derivatives, pyridine derivatives, pyrazine derivatives, pyrimidine derivatives, triazine derivatives, quinoline derivatives, phenanthroline derivatives, phthalocyanine derivatives, porphyrin derivatives, silole derivatives, oligothiophene derivatives, fused-ring aromatic derivatives, and metal complexes.

Examples thereof furthermore include polyvinylcarbazole derivatives, polyarylamine - derivatives, polyvinyltriphenylamine derivatives, polyfluorene derivatives, polyarylene derivatives, poly(arylene ether sulfone) derivatives containing tetraphenylbenzidine, polyarylenevinylene derivatives, polysiloxane derivatives, polythiophene derivatives, and poly(p-phenylenevinyle) derivatives. These derivatives may be any of alternating copolymers, random copolymers, block copolymers, and graft copolymers. Furthermore, the derivatives may be high-molecular compounds in which the main chain has one or more branches and which have three or more ends, or may be the so-called dendrimers.

Preferred of those are polyarylamine derivatives and polyarylene derivatives. The polyarylamine derivatives preferably are polymers containing a repeating unit represented by the following formula (II). Especially preferred are polymers each made up of repeating units represented by the following formula (II). In this case, such a may be one in which the repeating units differ in Ar^{a} or Ar^{b}.

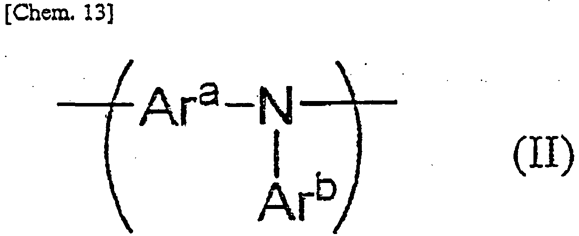

(In formula (II), Ar^{a} and Ar^{b} each independently represent an aromatic hydrocarbon group or aromatic heterocyclic group which may have a substituent.)

Examples of the aromatic hydrocarbon group which may have a substituent include groups derived from a six-membered monocycle or a di- to pentacyclic fused ring, such as a benzene ring, naphthalene ring, anthracene ring, phenanthrene ring, perylene ring, tetracene ring, pyrene ring, benzpyrene ring, chrysene ring, triphenylene ring, acenaphthene ring, fluoranthene ring, or fluorene ring. Examples thereof further include groups each made up of two or more rings selected from these rings and linked together through a direct bond.

Examples of the aromatic heterocyclic group which may have a substituent include groups derived from a five- or six-membered monocycle or a di- to tetracyclic fused ring, such as a furan ring, benzofuran ring, thiophene ring, benzothiophene ring, pyrrole ring, pyrazole ring, imidazole ring, oxadiazole ring, indole ring, carbazole ring, pyrroloimidazole ring, pyrrolopyrazole ring, pyrrolopyrrole ring, thienopyrrole ring, thienothiophene ring, furopyrrole ring, furofuran ring, thienofuran ring, benzisoxazole ring, benzisothiazole ring, benzimidazole ring, pyridine ring, pyrazine ring, pyridazine ring, pyrimidine ring, triazine ring, quinoline ring, isoquinoline ring, cinnoline ring, quinoxaline ring, phenanthridine ring, benzimidazole ring, perimidine ring, quinazoline ring, quinazolinone ring, or azulene ring. Examples thereof further include groups each made up of two or more rings selected from these rings and linked together through a direct bond.

From the standpoints of solubility and heat resistance, it is preferred that Ar^{a} to Ar^{b} should each independently be a group derived from a ring selected from the group consisting of a benzene ring, naphthalene ring, anthracene ring, phenanthrene ring, triphenylene ring, pyrene ring, thiophene ring, pyridine ring, and fluorene ring, or be a group made up of two or more benzene rings linked together (e.g., a biphenyl group or a terphenyl group).

Preferred of these are a group derived from a benzene ring (phenyl group), a group made up of two benzene rings linked together (biphenyl group), and a group derived from a fluorene ring (fluorenyl group).

Examples of the substituents which may be possessed by the aromatic hydrocarbon groups and aromatic heterocyclic groups represented by Ar^{a} and Ar^{b} include alkyl groups, alkenyl groups, alkynyl groups, alkoxy groups, aryloxy groups, alkoxycarbonyl groups, dialkylamino groups, diarylamino groups, acyl groups, halogen atoms, haloalkyl groups, alkylthio groups, arylthio groups, silyl groups, siloxy groups, cyano, aromatic hydrocarbon ring groups, and aromatic heterocyclic groups.

Examples of the polyarylene derivatives include polymers having a repeating unit including an arylene group, such as an aromatic hydrocarbon group or an aromatic heterocyclic group, that may have substituents shown above as examples with regard to the Ar^{a} and Ar^{b} contained in formula (II).

It is preferred that the polyarylene derivatives should be polymers having repeating units of the following formula (III-1) and/or the following formula (III-2).

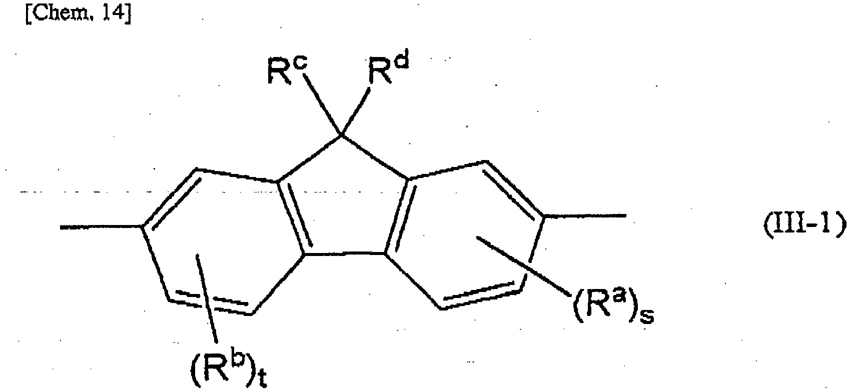

(In formula (III-1), R^{a}, R^{b}, R^{c}, and R^{d} each independently represent an alkyl group, alkoxy group, phenylalkyl group, phenylalkoxy group, phenyl group, phenoxy group, alkylphenyl group, alkoxyphenyl group, alkylcarbonyl group, alkoxycarbonyl group, or carboxy group. Symbols t and s each independently represent an integer of 0-3. When t or s is 2 or larger, then the multiple R^{a}s or R^{b}s contained in each molecule may be the same or different, and adjacent R^{a}s or R^{b}s may have been bonded to each other to form a ring.)

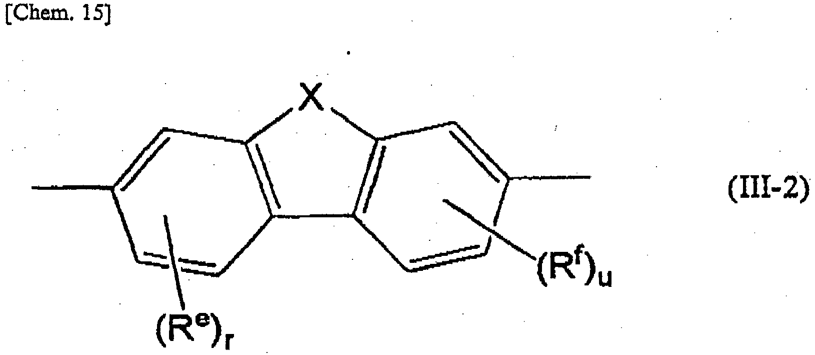

(In formula (III-2), R^{c} and R^{f} each independently have the same meaning as the R^{a}, R^{b}, R^{c}, or R^{d} contained in formula (III-1). Symbols r and u each independently represent an integer of 0-3. When r or u is 2 or larger, then the multiple R^{c}s or R^{f}s contained in each molecule may be the same or different, and adjacent R^{e}s or R^{f}s may have been bonded to each other to form a ring. X represents an atom or a group of atoms as a component of the five-membered ring or six-membered ring.)

Examples of X include -O-, -BR-, -NR-, -SiR₂-, -PR-, -SR-, -CR₂-, or a group made up of these atoms or groups bonded together. R represents a hydrogen atom or any desired organic group. The term "organic group" in the invention means a group containing at least one carbon atom.

It is also preferred that the polyarylene derivatives should have a repeating unit represented by the following formula (ITI-3) besides the repeating units of formula (III-1) and/or formula (III-2).

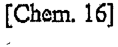

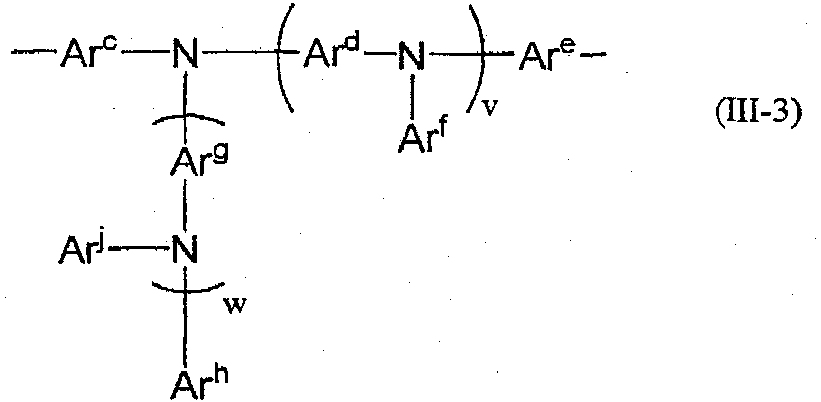

(In formula (III-3), Ar^{c} to Ar^{j} each independently represent an aromatic hydrocarbon group or aromatic heterocyclic group which may have a substituent. Symbols v and w each independently represent 0 or 1.)

Examples of Ar^{c} to Ar^{j} are the same as the examples of the Ar^{a} and Ar^{b} contained in formula (II).

Examples of formula (III-1) to (III-3), examples of the polyarylene derivatives, etc. include the examples given in JP-A-2008-98619. In the case where the hole transparent layer 4 is to be formed by a wet film formation method, a composition for hole transport layer formation is prepared, subsequently formed into a film by a wet film formation, and then heated and dried, as in the formation of the hole injection layer 3.

The composition for hole transport layer formation contains a solvent besides the hole-transporting compound described above. The solvent to be used may be the same as the solvent used in the composition for hole injection layer formation. Film formation conditions, heating/drying conditions, and the like also are the same as in the formation of the hole injection layer 3.

Also in the case where a hole transport layer is to be formed by the vacuum deposition method, conditions for the deposition and other conditions may be the same as in the formation of the hole injection layer 3.

The hole transport layer 4 may contain various luminescent materials, electron-transporting compounds, binder resins, applicability improvers, etc., besides the hole-transporting compound.

The hole transport layer 4 may also be a layer formed by crosslinking a crosslinkable compound. When a hole transport layer is formed, use of a crosslinkable compound can bring about a large difference in solubility in solvents. Use of the compound is hence preferred from the standpoint of facilitating the formation of a layer on the hole transport layer by a wet film formation method.

The crosslinkable compound is a compound which has a crosslinkable group and forms a network high-molecular compound through crosslinking.

Examples of the crosslinkable group include groups derived from a cyclic ether, such as oxetane and epoxy, groups derived from an unsaturated double bond, such as vinyl, trifluorovinyl, styryl, acryloyl, methacryloyl, and cinnamoyl; and groups derived from benzocyclobutene.

The crosslinkable compound may be any of a monomer, an oligomer, and a polymer. One crosslinkable compound may be used alone, or two or more crosslinkable compounds may be contained in any desired combination and proportion.

As the crosslinkable compound, it is preferred to use a hole-transporting compound having a crosslinkable group. Examples of the hole-transporting compound include the hole-transporting compounds shown above as examples, and examples of the hole-transporting compound having a crosslinkable group include such hole-transporting compounds in which a crosslinkable group has been bonded to the main chain or a side chain thereof. It is especially preferred that a crosslinkable group should have been bonded to the main chain through a linking group such as, for example, an alkylene group. Furthermore, it is especially preferred that the hole-transporting compound should be a polymer containing a repeating unit having a crosslinkable group, and should be a polymer having a repeating unit represented by any of formulae (II) and (III-1) to (III-3) to which a crosslinkable group has been bonded either directly or through a linking group.

As the crosslinkable compound, it is preferred to use a hole-transporting compound having a crosslinkable group. Examples of the hole-transporting compound include nitrogen-containing aromatic compound derivatives such as pyridine derivatives, pyrazine derivatives, pyrimidine derivatives, triazine derivatives, quinoline derivatives, phenanthroline derivatives, carbazole derivatives, phthalocyanine derivatives, and porphyrin derivatives; triphenylamine derivatives; silole derivatives; oligothiophene derivatives; fused-ring aromatic derivatives; and metal complexes. Preferred of these are: nitrogen-containing aromatic derivatives such as pyridine derivatives, pyrazine derivatives, pyrimidine derivatives, triazine derivatives, quinoline derivatives, phenanthroline derivatives, and carbazole derivatives; and triphenylamine derivatives, silole derivatives, fused-ring aromatic derivatives, metal complexes, and the like. In particular, triphenylamine derivatives are more preferred.

Although the crosslinkable compound may be any compound having any of the crosslinkable groups shown above, a high-molecular compound represented by the following formula (X) is preferred especially from the standpoint that film cracking and aggregation of polymer main chains are less apt to occur during crosslinking reaction.

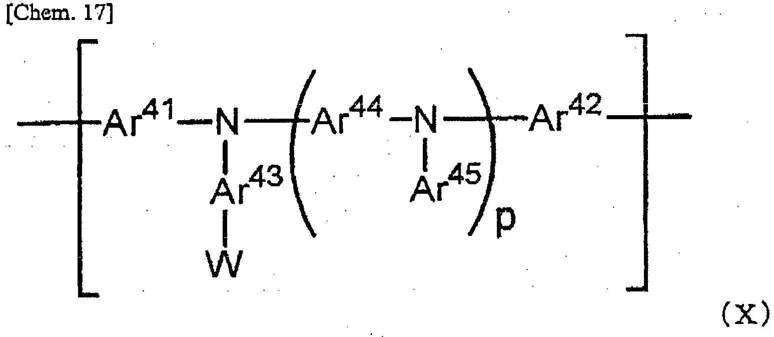

(In the formula, Ar⁴¹ and Ar⁴² each independently represent an aromatic hydrocarbon group which may have a substituent, an aromatic heterocyclic group which may have a substituent, or a direct bond, and

Ar⁴³ and Ar⁴⁵ each independently represent an aromatic hydrocarbon group which may have a substituent or an aromatic heterocyclic group which may have a substituent.

Symbol p represents an integer of 0-3.

W represents a crosslinkable group.)

Ar⁴¹ and Ar⁴² represent an aromatic hydrocarbon group which may have a substituent, an aromatic heterocyclic group which may have a substituent, or a direct bond, and Ar⁴³ to Ar⁴⁵ represent an aromatic hydrocarbon group which may have a substituent or an aromatic heterocyclic group which may have a substituent.

Examples of Ar⁴¹ to Ar⁴⁵ include the examples of <Ar¹ and Ar²> of formula (I). Preferred groups also are the same.

Examples of the substituents which may be possessed by Ar⁴¹ to Ar⁴⁵ include the {Substituents Z} shown above. Preferred groups also are the same.

Symbol p in formula (X) represents an integer of 0-3.

It is preferred that p should be 0, from the standpoint that this crosslinkable polymer has enhanced solubility in solvents and enhanced film-forming properties.

From the standpoint that the crosslinkable polymer has improved hole-transporting ability, it is preferred that p should be 1 to 3.

W in formula (X) represents a crosslinkable group. The crosslinkable group preferably is a group selected from the {Crosslinkable Groups T} shown above.

The crosslinkable group W may be directly bonded to the Ar⁴³, or may be bonded through a divalent group which is composed of 1 to 30 units selected from -O-, -G(=O)-, and (optionally substituted) -CH₂- groups and linked together in any desired order.

Preferred examples of the crosslinkable polymer in the invention are shown below, but the invention should not be construed as being limited to the examples. 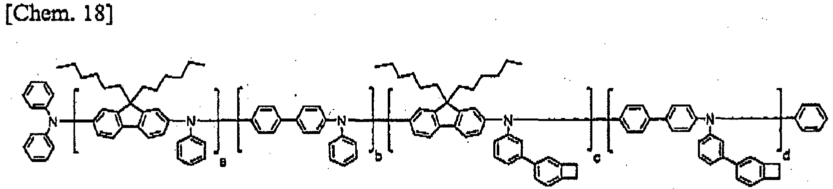 (Examples include the polymer of the formula in which a=0.475, b=0.475, c=0.025, and d=0.025.) 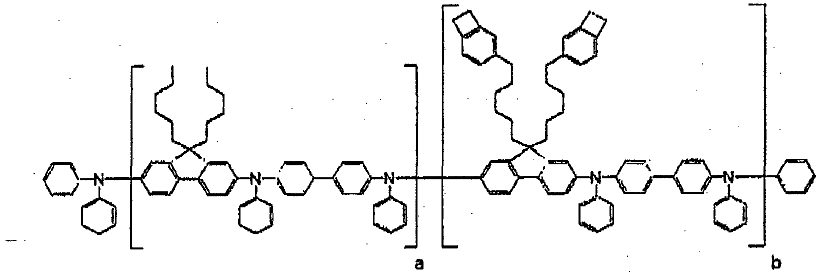 (Examples include the polymer of the formula in which a=0.9 and b=0.1.) 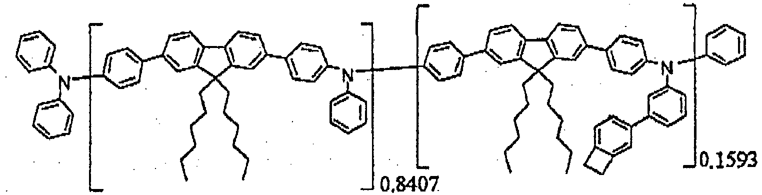 (Examples include the polymer of the formula in which a=0.8407 and b=0.1593.) 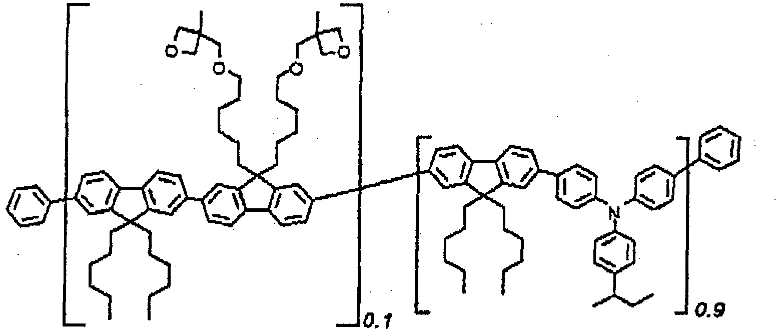 (Examples include the polymer of the formula in which a=0.1 and b=0.9.) 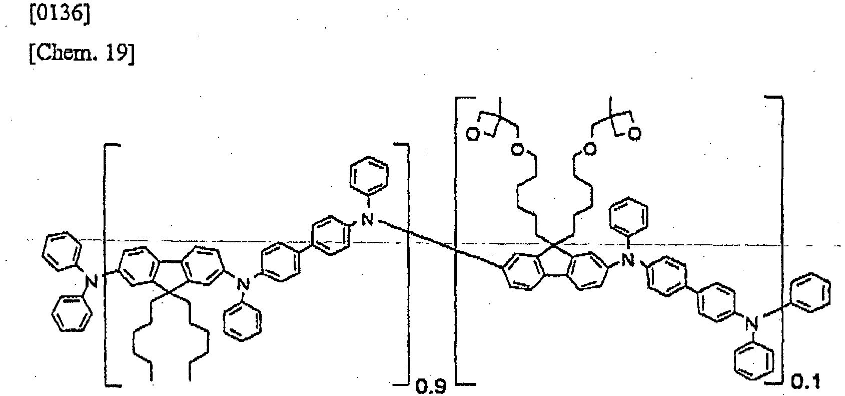 (Examples include the polymer of the formula in which a=0.9 and b=0.1.) 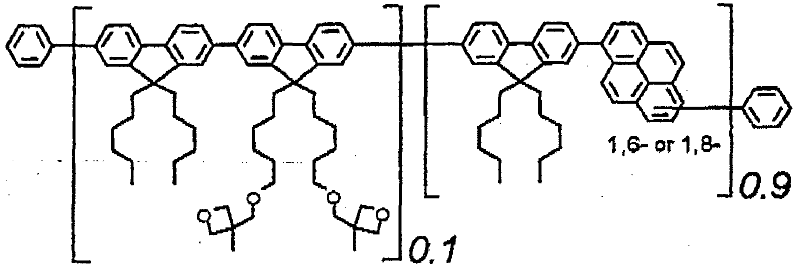 (Examples include the polymer of the formula in which a=0.1 and b=0.9.) 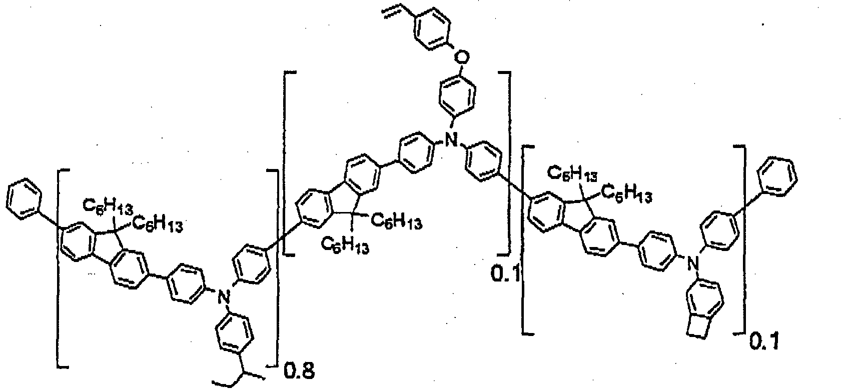 (Examples include the polymer of the formula in which a=0.8, b=0.1, and c-0.1.) 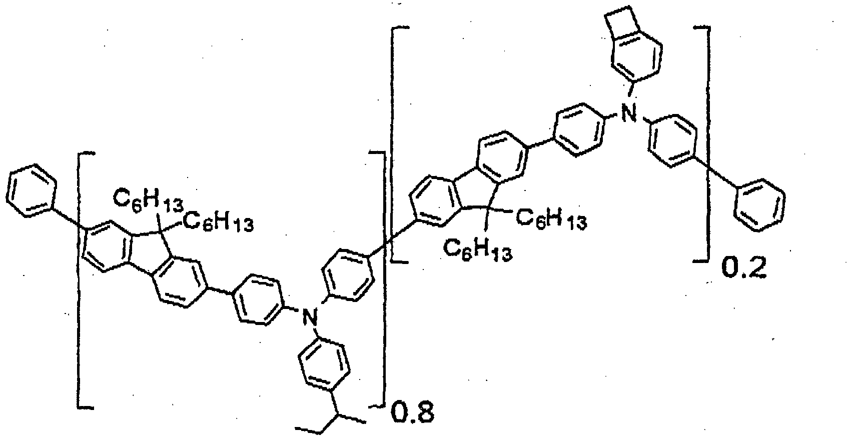 (Examples include the polymer of the formula in which a=0.8 and b=0.2.) 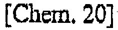 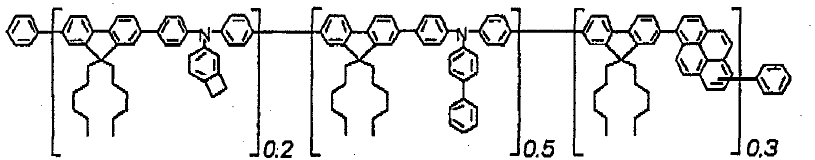 (Examples include the polymer of the formula in which a=0.2, b=0.5, and c=0.3.) 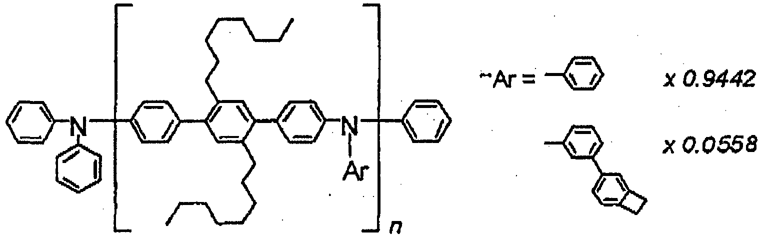 (Examples include the polymer of the formula in which a=0.9442 and b=0.0558.) 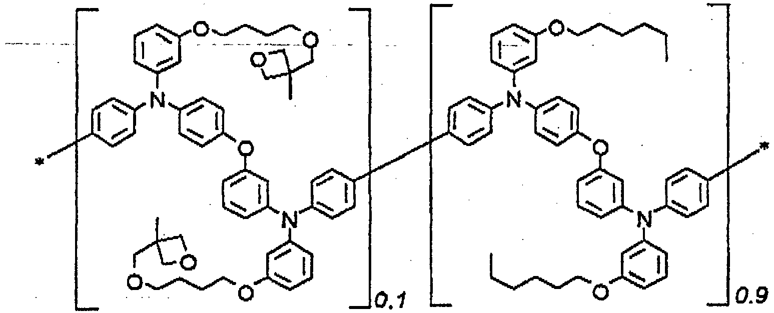 (Examples include the polymer of the formula in which a=0.1 and b=0.9.) 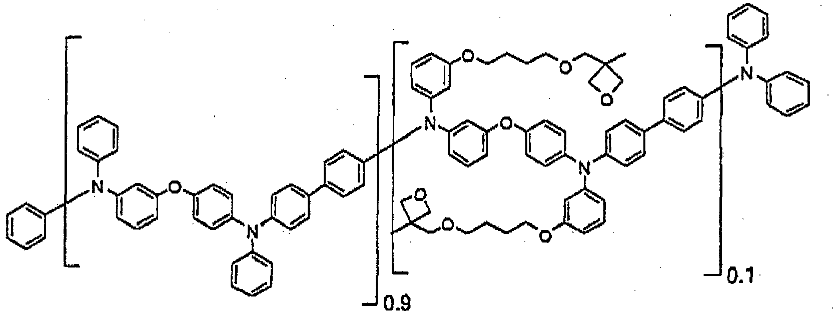 (Examples include the polymer of the formula in which a=0.9 and b=0.1.) 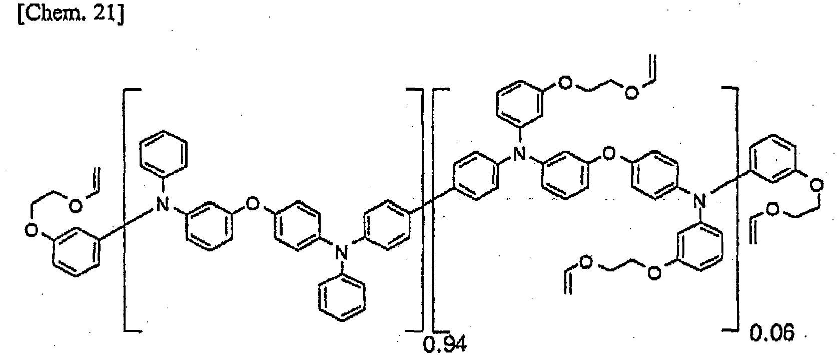 (Examples include the polymer of the formula in which a=0.94 and b=0.06.) 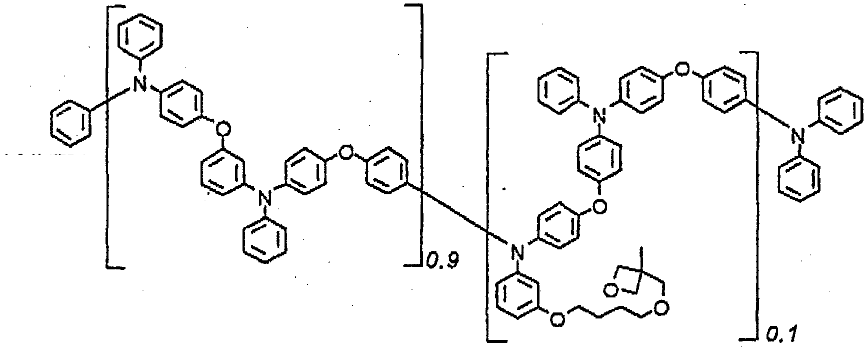 (Examples include the polymer of the formula in which a=0.9 and b=0.1.) 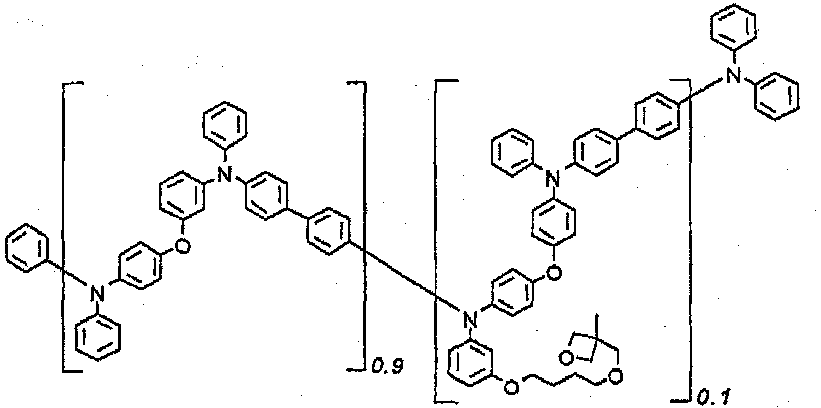 (Examples include the polymer of the formula in which a=0.9 and b=0.1.)

For forming a hole transport layer 4 through crosslinking of a crosslinkable compound, use is generally made of a method which includes dissolving or dispersing the crosslinkable compound in a solvent to prepare a composition for hole transport layer formation, forming this composition into a film by a wet film formation, and crosslinking the crosslinkable compound.

The composition for hole transport layer formation may contain an additive which accelerates the crosslinking reaction, besides the crosslinkable compound. Examples of the additive which accelerates the crosslinking reaction include polymerization initiators and polymerization accelerators, such as alkylphenone compounds, acylphosphine oxide compounds, metallocene compounds, oxime ester compounds, azo compounds, and onium salts; and photosensitizers such as fused-ring hydrocarbons, porphyrin compounds, and diaryl ketone compounds.

The composition may further contain an applicability improver such as a leveling agent or a defoamer, an electron-accepting compound, a binder resin, and the like.

The amount of the crosslinkable compound contained in the composition for hole transport layer formation is generally 0.01% by weight or more, preferably 0.05% by weight or more, more preferably 0.1% by weight or more, and is generally 50% by weight or less, preferably 20% by weight or less, more preferably 10% by weight or less.

The composition for hole transport layer formation which contains a crosslinkable compound in such a concentration is applied to the layer to be an underlying layer (usually, the hole injection layer 3) to form a film. Thereafter, the crosslinkable compound is crosslinked by means of heating and/or irradiation with electromagnetic energy, such as light, to thereby form a network high-molecular compound.

Conditions including temperature and humidity for the film formation are the same as in the wet film formation for forming the hole injection layer 3.

Techniques for heating to be conducted after film formation are not particularly limited. With respect to heating temperature conditions, the temperature is generally 120°C or higher and is preferably 400°C or lower.

The heating period is generally 1 minute or longer but preferably 24 hours or shorter. Although methods for heating are not particularly limited, use may be made, for example, of a method in which the multilayer structure having the layer formed is put on a hot plate or heated in an oven. For example, use can be made of conditions under which the multilayer structure is heated on a hot plate at 120°C or higher for 1 minute or longer.

In the case of irradiation with electromagnetic energy such as light, examples of methods therefor include a method in which an ultraviolet, visible, or infrared light source, e.g., an ultrahigh-pressure mercury lamp, high-pressure mercury lamp, halogen lamp, or infrared lamp, is used to directly irradiate the layer and a method in which a mask aligner or conveyor type irradiator that has any of those light sources built therein is used to irradiate the layer. With respect to irradiation with electromagentic energy other than light, examples of methods therefor include a method in which an apparatus for irradiating with microwaves generated by a magnetron, i.e., the so-called electronic oven, is used for the irradiation. With respect to irradiation period, it is preferred to set conditions necessary for reducing the solubility of the film. However, the film may be irradiated for a period of generally 0.1 sec or longer but preferably 10 hours or shorter.

Heating and irradiation with electromagentic energy, e.g., light, may be conducted alone or in combination. In the case where heating and the irradiation are conducted in combination, the sequence of performing these is not particularly limited.

The thickness of the hole transport layer 4 thus formed is generally 5 nm or more, preferably 10 nm or more, and is generally 300 nm or less, preferably 100 nm or less.

### [Luminescent Layer]

A luminescent layer 5 is disposed on the hole injection layer 3, or is disposed on the hole transport layer 4 when the hole transport layer 4 has been disposed. The luminescent layer 5 is a layer which, between the electrodes placed in an electric field, is excited by recombination of holes injected from the anode 2 with electrons injected from the cathode 9 and which thus functions as the main luminescence source.

The luminescent layer 5 may be formed using the materials and method described above in the section <Luminescent Layer>. Preferred embodiments also are the same.

The thickness of the luminescent layer 5 is not limited unless the effects of the invention are considerably lessened. However, the thickness thereof is generally 3 nm or more, preferably 5 nm or more, and is generally 200 nm or less, preferably 100 nm or less. In case where the thickness of the luminescent layer 5 is too small, there is a possibility that the film might have defects. In case where the thickness thereof is too large, there is the possibility of resulting in an increase in operating voltage.

### [Hole Blocking Layer]

A hole blocking layer 6 may be disposed between the luminescent layer 5 and the electron injection layer 8 which will be described later. The hole blocking layer 6 is a layer superposed on the luminescent layer 5 so as to be in contact with that interface of the luminescent layer 5 which faces the cathode 9.

This hole blocking layer 6 has the function of blocking holes sent from the anode 2 and preventing the holes from reaching the cathode 9, and further has the function of efficiently transporting, toward the luminescent layer 5, electrons injected from the cathode 9.

Examples of properties which are required of the material constituting the hole blocking layer 6 include a high electron mobility and a low hole mobility, a large energy gap (difference between HOMO and LUMO), and a high excited-triplet level (T1). Examples of materials for the hole blocking layer which satisfy such requirements include metal complexes such as mixed-ligand complexes, e.g., bis(2-methyl-8-quinolinolato)(phenolato)aluminum and bis(2-methyl-8-quinolinolato)(triphenylsilanolato)aluminum, and dinuclear metal complexes such as bis(2-methyl-8-quinolato)aluminum-µ-oxobis(2-methyl-8-quinolilato)aluminum, styryl compounds such as distyrylbiphenyl derivatives (JP-A-11-242996), triazole derivatives such as 3-(4-biphenylyl)-4-phenyl-5(4-tert-butylphenyl)-1,2,4-triazole (JP-A-7-41759), and phenanthroline derivatives such as bathocuproine (JP-A-10-79297). Furthermore, the compound having at least one pyridine ring substituted in the 2-, 4-, and 6-positions which is described in International Publication No. 2005/022962 is also preferred as a material for the hole blocking layer 6.

One material only may be used for forming the hole blocking layer 6, or two or more materials may be used for forming the layer 6 in any desired combination and proportion.

Methods for forming the hole blocking layer 6 are not limited. Consequently, the hole blocking layer 6 can be formed by a wet film formation method, vapor deposition, or another method.

The thickness of the hole blocking layer 6 is not limited unless the effects of the invention are considerably lessened. However, the thickness thereof is generally 0.3 nm or more, preferably 0.5 mn or more, and is generally 100 nm or less, preferably 50 nm or less.

### [Electron Transport Layer]

An electron transport layer 7 may be disposed between the luminescent layer 5 and the electron injection layer 8 which will be described later.

The electron transport layer 7 is disposed for the purpose of further improving the luminescent efficiency of the element, and is constituted of one or more compounds which, between the electrodes placed in an electric field, can efficiently transport, toward the luminescent layer 5, electrons injected from the cathode 9.

As electron-transporting compounds for the electron transport layer 7, use is made of compounds which attain a high efficiency of electron injection from the cathode 9 or electron injection layer 8 and which have a high electron mobility and can efficiently transport injected electrons. Examples of compounds satisfying such requirements include metal complexes such as the aluminum complex of 8-hydroxyquinoline (JP-A-59-194393), metal complexes of 10-hydroxybenzo[h]quinoline, oxadiazole derivatives, distyrylbiphenyl derivatives, silole derivatives, 3-hydroxyflavone metal complexes, 5-hydroxyflavone metal complexes, benzoxazole metal complexes, benzthiazole metal complexes, trisbenzimidazolylbenzene (U.S. Patent No. 5,645,948), quinoxaline compounds (JP-A-6-207169), phenanthroline derivatives (JP-A-5-331459), 2-t-butyl-9,10-N,N'-dicyanoanthraquinonediimine, n-type amorphous silicon hydride carbide, n-type zinc sulfide, and n-type zinc selenide.

One material only may be used for forming the electron transport layer 7, or two or more materials may be used for forming the layer 7 in any desired combination and proportion.

Methods for forming the electron transport layer 7 are not limited. Consequently, the electron transport layer 7 can be formed by a wet film formation method, vapor deposition, or another method.

The thickness of the electron transport layer 7 is not limited unless the effects of the invention are considerably lessened. However, the thickness thereof is generally 1 nm or more, preferably 5 nm or more, and is generally 300 nm or less, preferably 100 nm or less.

### [Electron Injection Layer]

The electron injection layer 8 has the function of efficiency injecting, into the luminescent layer 5, electrons injected from the cathode 9. From the standpoint of efficiently injecting electrons, it is preferred that the material constituting the electron injection layer 8 should be a metal having a low work function. For example, an alkali metal such as sodium or cesium, an alkaline earth metal such as barium or calcium, or the like is used. The thickness thereof is generally 0.1 nm or more and is preferably 5 nm or less.

Furthermore, doping of an organic electron transport compound represented by a nitrogen-containing heterocyclic compound, e.g., bathophenanthroline, or a metal complex, e.g., the aluminum complex of 8-hydroxyquinoline, with an alkali metal such as sodium, potassium, cesium, lithium, or rubidium (described in JP-A-10-270171, JP-A-2002-100478, JP-A-2002-100482, etc.) is preferred because this doping improves suitability for electron injection and transport and enables the layer to combine the improved suitability and excellent film quality. The thickness of the film in this case is generally 5 nm or more, especially preferably 10 nm or more, and is generally 200 nm or less, especially preferably 100 nm or less.

One material only may be used for forming the electron injection layer 8, or two or more materials may be used for forming the layer 8 in any desired combination and proportion.

Methods for forming the electron injection layer 8 are not limited. Consequently, the electron injection layer 8 can be formed by a wet film formation method, vapor deposition, or another method.

### [Cathode]

The cathode 9 has the function of injecting electrons into a layer located on the luminescent layer 5 side (e.g., the electron injection layer 8 or the luminescent layer 5).

As the material of the cathode 9, the materials usable for the anode 2 can be used. However, metals having a low work function are preferred from the standpoint of efficiently injecting electrons. For example, suitable metals such as tin, magnesium, indium, calcium, aluminum, and silver and alloys of these are used. Specific examples thereof include electrodes of alloys having a low work function, such as magnesium-silver alloys, magnesium-indium alloys, and aluminum-lithium alloys.

One material only may be used for forming the cathode 9, or two or more materials may be used for forming the cathode 9 in any desired combination and proportion.

The thickness of the cathode 9 is generally the same as that of the anode 2,

For the purpose of protecting the cathode 9 made of a metal having a low work function, a layer of a metal which has a high work function and is stable to the air may be formed on the cathode 9. This layer formation is preferred because the stability of the element is enhanced thereby. For this purpose, a metal such as, for example, aluminum, silver, copper, nickel, chromium, gold, or platinum is used. One of these materials may be used alone, or two or more thereof may be used in any desired combination and proportion.

### [Other Layers]

The organic electroluminescence element made by the method of the invention may have other configurations unless the configurations depart from the spirit of the invention. For example, unless the performance of the element is impaired, the element may have any desired layer other than the layers explained above, between the anode 2 and the cathode 9, or any desired layer may have been omitted.

### {Electron Blocking Layer}

Examples of the layers which may be possessed include an electron blocking layer.

The electron blocking layer is disposed between the hole injection layer 3 or hole transport layer 4 and the luminescent layer 5. The electron blocking layer serves to block electrons sent from the luminescent layer 5 and prevent the electrodes from reaching the hole injection layer 3. The electron blocking layer thus functions to heighten the probability of recombination of holes with electrons within the luminescent layer 5 and to confine the resultant excitons in the luminescent layer 5. The electron blocking layer further has the function of efficiently transporting, toward the luminescent layer 5, holes injected from the hole injection layer 3. To dispose the electron blocking layer is effective especially when a phosphorescent material or a blue luminescent material is used as a luminescent material.

Examples of properties which are required of the electron blocking layer include high hole-transporting properties, a large energy gap (difference between HOMO and LUMO), and a high excited-triplet level (T1). Furthermore, in the invention, when the luminescent layer 5 is to be formed as an organic layer according to the invention by a wet film formation method, the electron blocking layer also is required to have suitability for the wet film formation. Examples of materials usable for forming such an electron blocking layer include copolymers of dioctylfluorene and triphenylamine which are represented by F8-TFB (International Publication No. 2004/084260).

One material only may be used for forming the electron blocking layer, or two or more materials may be used for forming the layer in any desired combination and proportion.

Methods for forming the electron blocking layer are not limited. Consequently, the electron blocking layer can be formed by a wet film formation method, vapor deposition, or another method.

Furthermore, to interpose an ultrathin insulating film (0.1-5 nm) made of, for example, lithium fluoride (LiF), magnesium fluoride (MgF₂), lithium oxide (Li₂O), or cesium(II) carbonate (CsCO₃) at the interface between the cathode 9 and the luminescent layer 5 or electron transport layer 7 is an effective technique for improving the efficiency of the element (see, for example, Applied Physics Letters, Vo1.70, p.152, 1997; JP-A-10-74586; IEEE Transactions on Electron Devices, Vol.44, p.1245, 1997; and SID 04 Digest, p. 154).

### [Layer Configuration]

Moreover, in any of the layer configurations explained above, the constituent elements excluding the substrate may be superposed in the reverse order. For example, in the case of the layer configuration shown in Fig. 1, the constituent elements other than the substrate 1 may be disposed on the substrate 1 in the order of: the cathode 9, electron injection layer 8, electron transport layer 7, hole blocking layer 6, luminescent layer 5, hole transport layer 4, hole injection layer 3, and anode 2.

It is also possible to constitute an organic electroluminescence element according to the invention by superposing the constituent elements other than the substrate between two substrates, at least one of which is transparent.

A structure composed of a stack of stages each composed of constituent elements other than substrates (luminescent units) (i.e., a structure composed of a plurality of stacked luminescent units) is also possible. In this case, when a carrier generation layer (CGL) made of, for example, vanadium pentoxide (V₂O₅) is disposed in place of the interfacial layers located between the stages (i.e., between the luminescent units) (when the anode is ITO and the cathode is aluminum, the interfacial layers are these two layers), then the barrier between the stages is reduced. This configuration is more preferred from the standpoints of luminescent efficiency and operating voltage.

Furthermore, the organic electroluminescence element made by the method of the invention may be configured so as to be a single organic electroluminescence element, or may be applied to a configuration in which a plurality of organic electroluminescence elements have been disposed in an array arrangement. The organic electroluminescence element may also be applied to a configuration in which anodes and cathodes have been disposed in an X-Y matrix arrangement.

Each of the layers described above may contain ingredients other than those described above as materials for the layer, unless the effects of the invention are considerably lessened thereby.

### <Organic EL Display>

The organic EL display employs the organic electroluminescence element made by the method of the invention described above. The type and structure of the organic EL display of the invention are not particularly limited, and can be fabricated using the organic electroluminescence element of the invention according to ordinary methods.

For example, the organic EL display of the invention can be formed by the method described in Yuki EL Dispurei (Ohmsha, Ltd., published on August 20, 2004, written by TOKITO Shizuo, ADACHI Chihaya, and MURATA Hideyuki).

### <Organic EL lighting>

The organic EL lighting made by the method of the invention employs the organic electroluminescence element of the invention described above. The type and structure of the organic EL lighting of the invention are not particularly limited, and can be fabricated using the organic electroluminescence element of the invention according to ordinary methods.

### Examples

The invention will be explained below in more detail by reference to Examples, but the invention should not be construed as being limited to the following Examples

### [Measurement of Dielectric Constant]

### (Reference Example 1)

An element for dielectric constant measurement which had the structure shown in Fig. 2 was produced, A substrate constituted of a glass substrate and, formed thereon, a transparent conductive film of indium-tin oxide (ITO) deposited in a thickness of 70 nm (deposited by sputtering; manufactured by Sanyo Vacuum Industries Co., Ltd.) was subjected to processing by an ordinary technique of photolithography and etching with hydrochloric acid to pattern the transparent conductive film into stripes having a width of 2 mm, Thus, an anode 2 was formed. The ITO substrate which had undergone the patterning was cleaned by subjecting the substrate to ultrasonic cleaning with an aqueous surfactant solution, rinsing with ultrapure water, ultrasonic cleaning with ultrapure water, and rinsing with ultrapure water in this order, subsequently dried with compressed air, and finally subjected to ultraviolet/ozone cleaning. This ITO functions as an electrode.

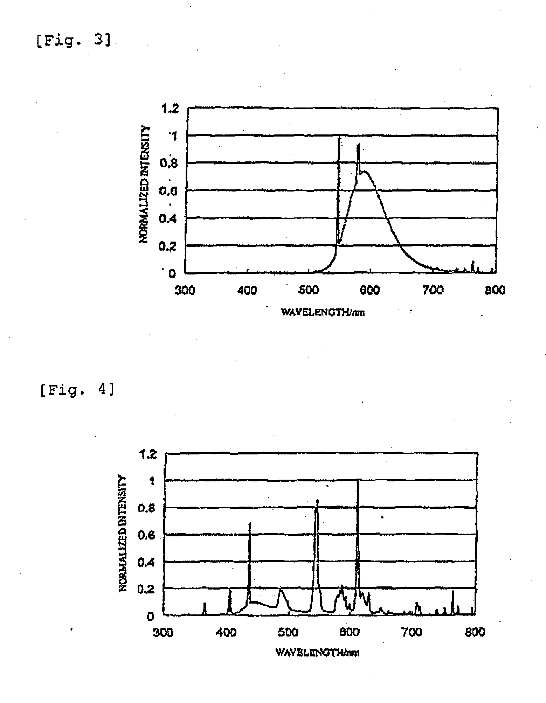

A coating fluid containing compound (C1), arylamine compound (C2), and compound (D1) respectively represented by the following structural formulae was prepared. The coating fluid was applied to the substrate having patterned ITO by spin coating and heated, under the following conditions in an environment having the spectrum shown in Fig. 3. Thus, a sample layer 10 was formed. This sample layer had a thickness of 206 nm.

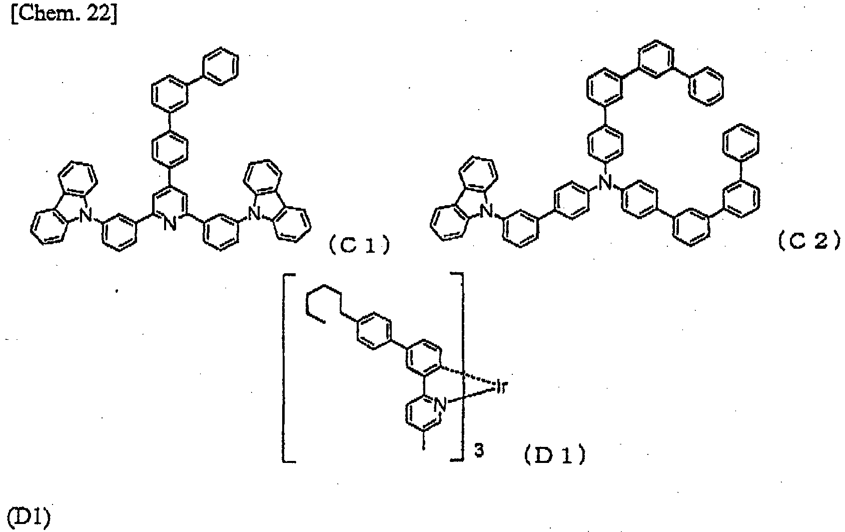

### <Coating Fluid for Sample Layer Formation>

Solvent toluene
Coating fluid concentrations
   C1: 0.75 wt%
   C2: 2.25 wt%
   D1: 0.30 wt%

### <Conditions for Forming Sample Layer 10>

| | |
|---|---|
| Spinner rotation speed | 500 rpm |
| Spinner rotation period | 30 sec |
| Spin coating atmosphere | in nitrogen |
| Heating conditions | 130°C; 1 hr; in nitrogen |

Here, the substrate was transferred to a vacuum deposition apparatus. A shadow mask in the form of stripes with a width of 2 mm was brought, as a mask for counter-electrode deposition, into close contact with the element so that these stripes were perpendicular to the ITO stripes of the electrode 2. The apparatus was evacuated until the degree of vacuum within the apparatus became at least 5.0×10⁻⁴ Pa.

Aluminum was heated using a molybdenum boat in the same manner to form an aluminum layer having a thickness of 80 nm as a counter electrode 9 while regulating the rate of deposition so as to be in the range of 1.0-10.0 Å/sec (1 nm = 10 Å).

Subsequently, sealing was conducted in the following manner in order to prevent the element from being deteriorated by the action of atmospheric moisture, etc. during storage.

In a gloved nitrogen box, a photocurable resin (30Y-437, manufactured by ThreeBond Co., Ltd.) was applied in a width of about 1 mm to the periphery of a glass plate having a size of 23 mm × 23 mm, and a moisture getter sheet (manufactured by Dynic Corp.) was disposed in a central part. The substrate on which the cathode had been formed was laminated to the getter sheet so that the side having the deposited layers faced the desiccant sheet. Thereafter, only the region where the photocurable resin had been applied was irradiated with ultraviolet light to cure the resin,

Thus, an element for dielectric constant measurement which had an area with a size of 2 mm × 2 mm was obtained. This element was examined with dielectric analysis system Model SI 126096W, manufactured by Solartron, while applying an alternating-current voltage of 100 mV thereto at 0.1 Hz to 10 kHz.

The values of dielectric constant obtained are shown in Table 1

### (Reference Example 2)

An element for dielectric constant measurement was produced in the same manner as in Reference Example 1, except that a sample layer 10 was formed in an environment having the spectrum shown in Fig. 4.

The values of dielectric constant obtained are shown in Table 1.

### (Reference Example 3)

An element for dielectric constant measurement was produced in the same manner as in Reference Example 1, except that a sample layer 10 having a thickness of 232 nm was formed by preparing a coating fluid containing compound (C3) and arylamine compound (D2) respectively represented by the following structural formulae and subjecting the coating fluid to application by spin coating and heating in an environment having the spectrum shown in Fig. 3.

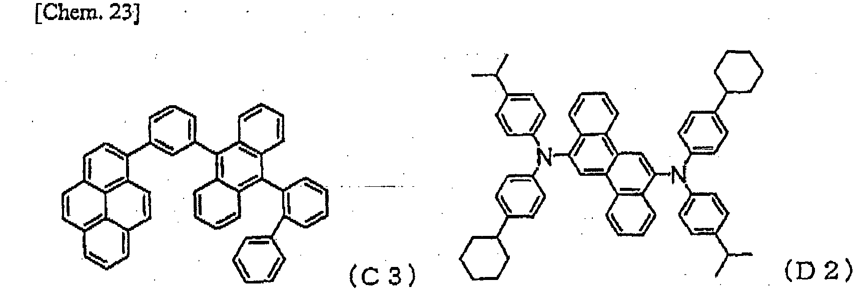

### <Coating Fluid for Sample Layer Formation>

Solvent toluene
Coating fluid concentrations
   C3: 3.0 wt%
   D2: 0.3 wt%

### <Conditions for Forming Sample Layer 10>

| | |
|---|---|
| Spinner rotation speed | 500 rpm |
| Spinner rotation period | 30 sec |
| Spin coating atmosphere | in nitrogen |
| Heating condition | 130°C; 1 hr; in nitrogen |

The values of dielectric constant obtained are shown in Table 1.

### (Reference Example 4) .

An element for dielectric constant measurement was produced in the same manner as in Reference Example 3, except that a sample layer 10 was formed by applying the coating fluid by spin coating in an environment having the spectrum shown in Fig. 4 and heating the applied coating fluid in the environment shown in Fig. 3.

The values of dielectric constant obtained are shown in Table 1.

[Table 1]

**Table 1**

| | Sample layer | Film formation environment | Dielectric constant at 0.1 Hz | Dielectric constant at 10 Hz | Dielectric constant at 1 kHz |
|---|---|---|---|---|---|
| Reference Example 1 | C1 | yellow | 1012.1 | 12.591 | 2.9768 |
| Reference Example 2 | C₂ | fluorescent lamp | 12991 | 139.72 | 3.6495 |
| | D1 | | | | |
| Reference Example 3 | C3 | yellow | 9935.2 | 104.48 | 3.3628 |
| Reference Example 4 | D2 | fluorescent lamp | 17158 | 171.60 | 4.1501 |

In the table, the underlined compounds are arylamine compounds.

It can be seen from Table 1 that the formation of a layer containing an arylamine compound in the fluorescent-lamp environment containing light having short wavelengths shorter than 500 nm resulted in larger values of dielectric constant as compared with the film formation conducted in the yellow environment containing no such short-wavelength components. This indicates that when a layer containing an arylamine compound is to be formed by a wet film formation, formation thereof in an environment containing short-wavelength components results in the generation of a larger amount of ion pairs.

### [Examination by TOF-SIMS]

### (Reference Example 5)

A substrate constituted of a glass substrate and, formed thereon, a transparent conductive film of indium-tin oxide (ITO) deposited in a thickness of 150 nm (deposited by sputtering; manufactured by Sanyo Vacuum Industries Co., Ltd.) was cleaned by subjecting the substrate to ultrasonic cleaning with an aqueous surfactant solution, rinsing with ultrapure water, ultrasonic cleaning with ultrapure water, and rinsing with ultrapure water in this order, subsequently dried with compressed air, and finally subjected to ultraviolet/ozone cleaning.

A coating fluid containing compound (C1), arylamine compound (C2), and compound (D1) respectively represented by the following structural formulae was prepared. The coating fluid was applied to the ITO substrate by spin coating and heated, under the following conditions in an environment having the spectrum shown in Fig. 3. Thus, an arylamine-containing layer having a thickness of 60 nm was formed to obtain a sample for TOF-SIMS examination.

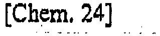

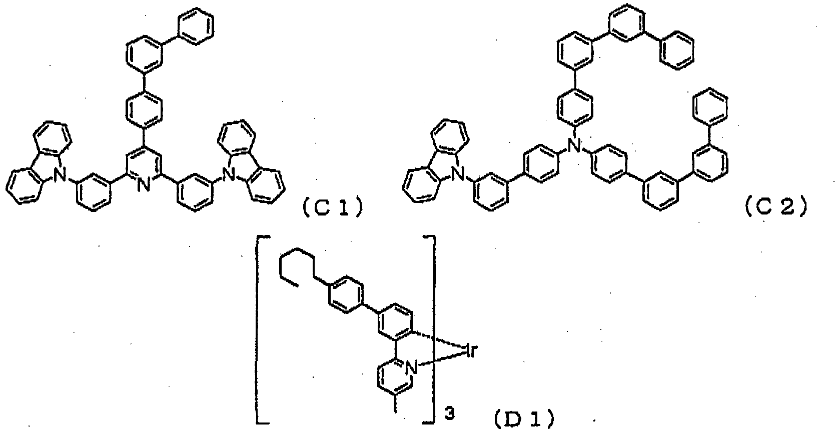

### <Coating Fluid for Forming Arylamine-Containing Layer>

Solvent CHB
Coating fluid concentrations
   C1: 1.25 wt%
   C2: 3.75 wt%
   D1: 0.50 wt%

### <Conditions for Forming Arylanime-Contaming Layer>

| | |
|---|---|
| Spinner rotation speed | 1,500 rpm |
| Spinner rotation period | 120 sec |
| Spin coating atmosphere | in nitrogen |
| Heating conditions | 130°C; 1 hr; in nitrogen |

This substrate was subjected to an examination by TOF-SIMS using TOF-SIMS IV, manufactured by ION-TOF GmbH. The substrate was bombarded with Bi₃⁺⁺ ions as primary ions under the conditions of an accelerating voltage of 25 kV, bombardment current of 0.1 pA, and scanning range of 200 µm × 200 µm, and the resultant positive secondary ions were collected and integrated over 30 scans to determine the molecular-ion intensity.

The value of molecular-ion intensity obtained for the arylamine compound (C2) is shown in Table 2.

### (Reference Example 6)

A sample for TOF-SIMS examination was produced in the same manner as in Reference Example 5, except that a dielectric layer 3 was formed by applying the coating fluid by spin coating in an environment having the spectrum shown in Fig. 4 and heating the applied coating fluid in the environment shown in Fig. 3.

The value of molecular-ion intensity obtained for the arylamine compound (C2) is shown in Table 2.

### (Reference Example 7)

A sample for TOF-SIMS examination was produced in the same manner as in Reference Example 5, except that an arylamine-containing layer having a thickness of 45 nm was formed by preparing a coating fluid containing compound (C3) and arylamine compound (D2) respectively represented by the following structural formulae and subjecting the coating fluid to application by spin coating and to heating under the following conditions in an environment having the spectrum shown in Fig. 3.

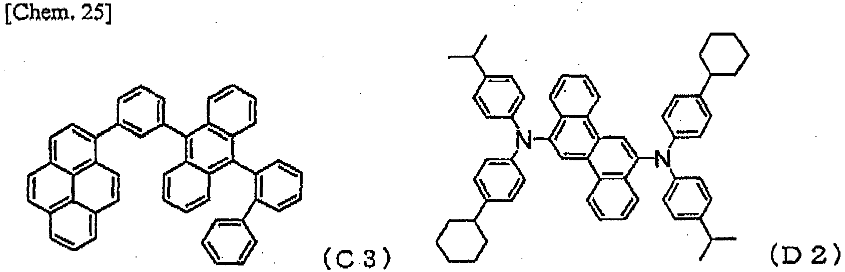

### <Coating Fluid for Forming Arylamine-Containing Layer>

Solvent cyclohexylbenzene (CHB)
Coating fluid concentrations
   C3: 3.10 wt%
   D2: 0.31 wt%

### <Conditions for Forming Arylamine-Containing Layer>

| | |
|---|---|
| Spinner rotation speed | 1,200 rpm |
| Spinner rotation period | 120 sec |
| Spin coating atmosphere | in nitrogen |
| Heating conditions | 130°C; 1 hr; in nitrogen |

The value of molecular-ion intensity obtained for the arylamine compound (D2) is shown in Table 2.

### (Reference Example 8)

An element for dielectric constant measurement was produced in the same manner as in Reference Example 7, except that an arylamine-containing layer was formed by applying the coating fluid by spin coating in an environment having the spectrum shown in Fig. 4 and heating the applied coating fluid in the environment shown in Fig. 3.

The value of molecular-ion intensity obtained for the arylamine compound (D2) is shown in Table 2.

[Table 2]

**Table 2**

| | Test sample | Film formation environment | Molecular-ion intensity of arylamine compound |
|---|---|---|---|
| Reference Example 5 | C1 | yellow | 907 |
| Reference Example 6 | C2 | fluorescent lamp | 901 |
| | D1 | | |
| Reference Example 7 | C3 | yellow | 34424 |
| Reference Example 8 | D2 | fluorescent lamp | 34171 |

In the table, the underlined compounds are arylamine compounds.

It can be seen from Table 2 that the intensity of molecular ions of each arylamine compound which are detected from layers containing the arylamine compound is not affected by the film formation environments. Namely, the results indicate that the compounds have not decomposed into completely different compounds. These results, coupled with the results of Reference Examples 1 to 4, show that the arylamine compounds formed into a film in the fluorescent-lamp environment have not decomposed into different compounds but become radical cations, and that the conversion into radical cations was inhibited by conducting the film formation in the yellow environment.

### [Production of Organic Electroluminescence elements]

### (EXAMPLE 1)

An organic electroluminescence element having the structure shown in Fig. 2 was produced. A substrate constituted of a glass substrate and, formed thereon, a transparent conductive film of indium-tin oxide (ITO) deposited in a thickness of 150 nm (deposited by sputtering; manufactured by Sanyo Vacuum Industries Co., Ltd.) was subjected to processing by an ordinary technique of photolithography and etching with hydrochloric acid to pattern the transparent conductive film into stripes having a width of 2 mm. Thus, an anode 2 was formed. The ITO substrate which had undergone the patterning was cleaned by subjecting the substrate to ultrasonic cleaning with an aqueous surfactant solution, rinsing with ultrapure water, ultrasonic cleaning with ultrapure water, and rinsing with ultrapure water in this order, subsequently dried with compressed air, and finally subjected to ultraviolet/ozone cleaning. This ITO functions as an electrode.

First, a coating fluid for hole injection layer formation including the arylamine polymer represented by the following structural formula (P1), 4-isopropyl-4'-methyldiphenyliodonium tetrakis(pentafluorophenyl) borate, which is represented by structural formula (A1), and ethyl benzoate was prepared. This coating fluid was applied to the patterned-ITO substrate by spin coating under the following conditions to form a film thereof on the anode. Thus, a hole injection layer having a thickness of 30 nm was obtained.

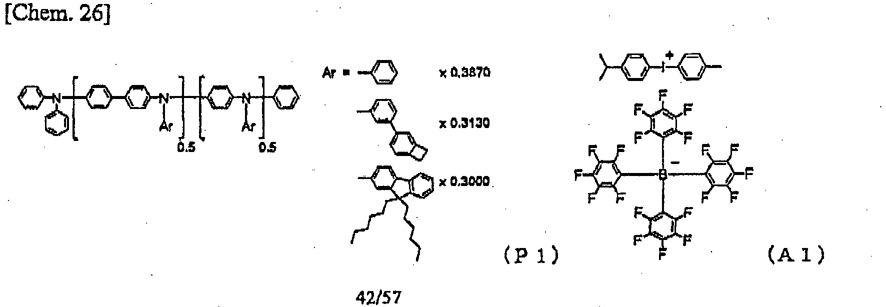

### <Coating Fluid for Hole Injection Layer Formation>

Solvent ethyl benzoate
Concentrations of coating fluid
   P1: 2.0 wt%
   A1: 0.4 wt%

### <Conditions for Forming Hole Injection Layer 3>

| | |
|---|---|
| Spinner rotation speed | 1,500 rpm |
| Spinner rotation period | 30 sec |
| Spin coating atmosphere | in the air |
| Heating conditions | in the air; 230°C; 1 hr |

Subsequently, a coating fluid for hole transport layer formation containing a compound represented by the following structural formula (H1) was prepared. This coating fluid was applied by spin coating and polymerized by heating, under the following conditions. Thus, a hole transport layer having a thickness of 20 nm was formed.

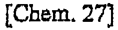

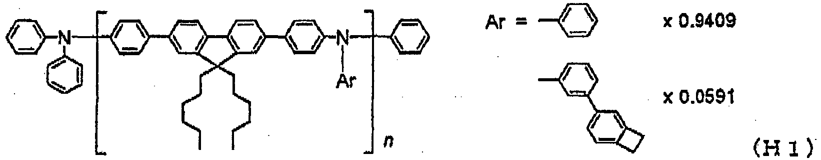

### <Coating Fluid for Hole Transport Layer Formation>

Solvent cyclohexylbenzene
Concentration of coating fluid 1.3 wt%

### <Conditions for Forming Hole Transport Layer 4>

| | |
|---|---|
| Spinner rotation speed | 1,500 rpm |
| Spinner rotation period | 120 sec |
| Spin coating atmosphere | in nitrogen |
| Heating conditions | 230°C; 1 hr; in nitrogen |

Next, a coating fluid for luminescent-layer formation containing compound (C1), arylamine compound (C2), and compound (D1) respectively represented by the following structural formulae was prepared. This coating fluid was applied by spin coating and heated, under the following conditions in an environment having the spectrum shown in Fig. 3. Thus, a luminescent layer having a thickness of 60 nm was formed.

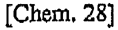

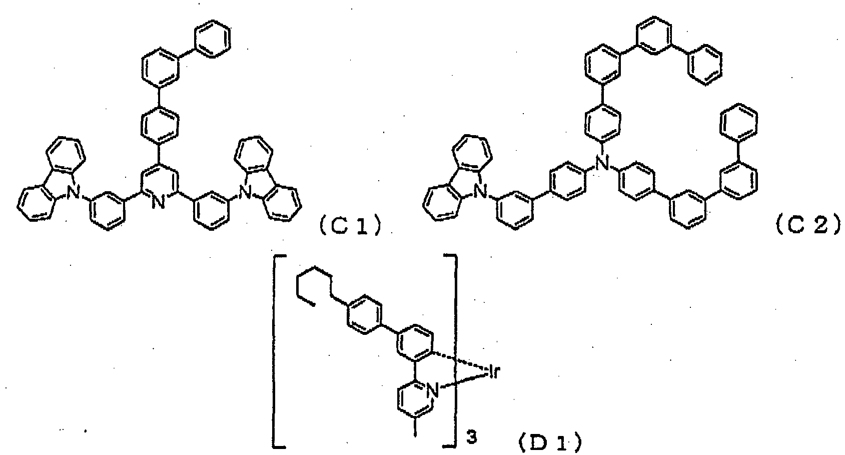

### <Coating Fluid for Luminescent-Layer Formation>

Solvent 1,2-dichloroethane (1,2-DCE)
Concentrations of coating fluid
   C1: 0.1 wt%
   C2: 0.3 wt%
   D1: 0.04 wt%

### <Conditions for Forming Luminescent Layer 5>

| | |
|---|---|
| Spinner rotation speed | 1700 rpm |
| Spinner rotation period | 30 sec |
| Spin coating atmosphere | in nitrogen |
| Heating conditions | 130°C; 1 hr; in nitrogen |

Here, the substrate on which the layers including the luminescent layer had been formed was transferred to a vacuum deposition apparatus, and the apparatus was evacuated to a degree of vacuum within the apparatus of at least 2.0×10⁻⁴ Pa. Thereafter, the organic compound (E1) having the structure shown below was deposited on the luminescent layer by vacuum deposition while regulating the rate of deposition so as to be in the range of 0.8-1.2 Å/sec. Thus, a hole blocking layer 6 having a thickness of 10 nm was obtained.

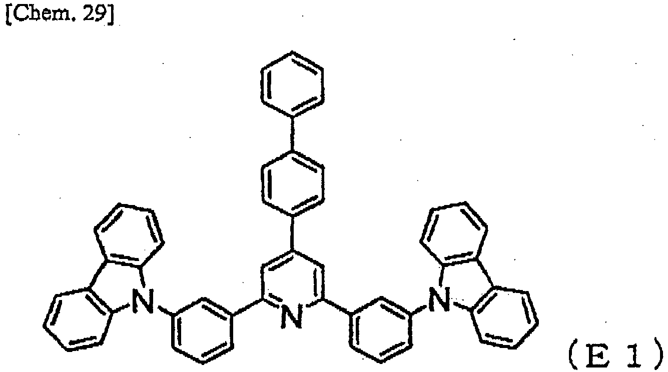

Subsequently, the organic compound (Alq3) having the structure shown below was deposited on the hole blocking layer 6 by vacuum deposition while regulating the rate of deposition so as to be in the range of 0.8-1.2 Å/sec. Thus, an electron transport layer 7 having a thickness of 30 nm was formed.

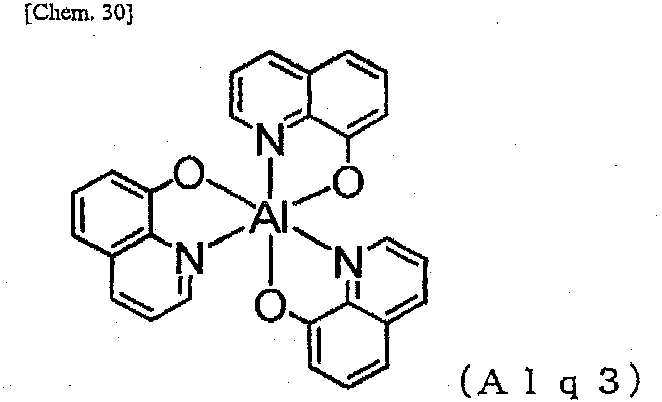

Here, the element in which the layers including the electron transport layer had been vapor-deposited was temporarily taken out and disposed in another vacuum deposition apparatus. A shadow mask in the form of stripes with a width of 2 mm was brought, as a mask for cathode deposition, into close contact with the element so that these stripes were perpendicular to the ITO stripes of the anode 2, and the apparatus was evacuated to a degree of vacuum within the apparatus of at least 5.0×10⁻⁴ Pa.

First, lithium fluoride (LiF) was deposited as an electron injection layer in a thickness of 0.5 nm on the electron transport layer 7 at a deposition rate of 0.1 Å/sec using a molybdenum boat. Next, aluminum was likewise heated using a molybdenum boat, and an aluminum layer having a thickness of 80 nm was formed as a cathode while regulating the rate of deposition so as to be in the range of 1.0-10.0 Å/sec. During the deposition of these two layers, the temperature of the substrate was kept at room temperature.

Subsequently, sealing was conducted in the following manner in order to prevent the element from being deteriorated by the action of atmospheric moisture, etc. during storage.

In a gloved nitrogen box, a photocurable resin (30Y-437, manufactured by ThreeBond Co., Ltd.) was applied in a width of about 1 mm to the periphery of a glass plate having a size of 23 mm × 23 mm, and a moisture getter sheet (manufactured by Dynic Corp.) was disposed in a central part. The substrate on which the cathode had been formed was laminated to the getter sheet so that the side having the deposited layers faced the desiccant sheet. Thereafter, only the region where the photocurable resin had been applied was irradiated with ultraviolet light to cure the resin.

Thus, an organic electroluminescence element having a luminescent area with a size of 2 mm × 2 mm was obtained. The voltage, efficiency, and chromaticity of this element are shown in Table 3, and the working lives thereof are shown in Table 4.

### (COMPARATIVE EXAMPLE 1)

An organic electroluminescence element was produced in the same manner as in Example 1, except that a luminescent layer 5 was formed by applying the coating fluid by spin coating in an environment having the spectrum shown in Fig. 4 and heating the applied coating fluid in the environment shown in Fig. 3.

The voltage, efficiency, and chromaticity of the organic electroluminescence element obtained are shown in Table 3, and the working lives thereof are shown in Table 4.

[Table 3]

**Table 3**

| | Solvent | Film formation environment for luminescent layer | Voltage at 1000 cd/m² (V) | Current efficiency at 1000 cd/m² (cd/A) | CIE chromaticity coordinates |
|---|---|---|---|---|---|
| Example 1 | 1,2-DCE | yellow | 8.2 | 31.8 | (0.34, 0.62) |
| Comparative Example 1 | 1,2-DCE | fluorescent lamp | 10.1 | 22.1 | (0,34, 0.62) |

[Table 4]

**Table 4**

| | Solvent | Film formation environment for luminescent layer | 70% luminance life in voltage application at 20 mA/cm² (h) | Initial luminance (cd/m²) | Converted life at 1,000 cd/m² (h) |
|---|---|---|---|---|---|
| Example 1 | 1,2-DCE | yellow | 90 | 6237 | 2428 |
| Comparative Example 1 | 1,2-DCE | fluorescent lamp | 13 | 4215 | 173 |

| | | | | | |
|---|---|---|---|---|---|
| * The 1.8th power was used as acceleration factor when each converted life in Table 4 was calculated. | | | | | |

It can be seen from Table 3 and Table 4 that the organic electroluminescence element according to the invention combines a high efficiency and a long life.

### (EXAMPLE 2)

An organic electroluminescence element was produced in the same manner as in Example 1, except that a luminescent layer 5 having a thickness of 45 nm was formed by preparing a coating fluid for luminescent-layer formation containing compound (C3) and arylamine compound (D2) respectively having the structures shown below and subjecting the coating fluid to application by spin coating and to heating under the following conditions in an environment having the spectrum shown in Fig. 3.

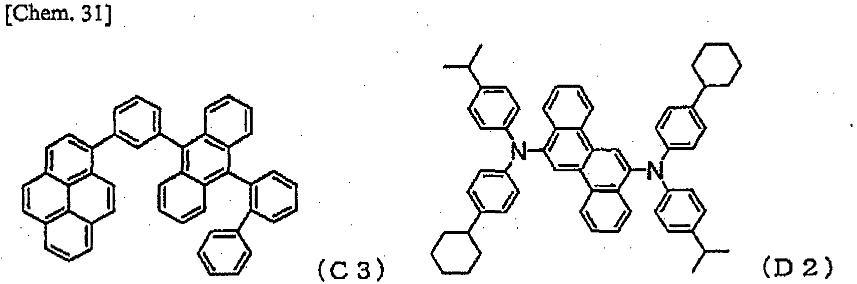

### <Coating Fluid for Luminescent-Layer Formation>

Solvent 1,2-DCE
Concentrations of coating fluid
   C3: 0.27 wt%
   D2: 0.03 wt%

### <Conditions for Forming Luminescent Layer 5>

| | |
|---|---|
| Spinner rotation speed | 1,700 rpm |
| Spinner rotation period | 30 sec |
| Spin coating atmosphere | in nitrogen |
| Heating conditions | 130°C; 1 hr; in nitrogen |

The voltage, efficiency, and chromaticity of the organic electroluminescence element obtained are shown in Table 5, and the working lives thereof are shown in Table 6.

### (COMPARATIVE EXAMPLE 2)

An organic electroluminescence element was produced in the same manner as in Example 2, except that a luminescent layer 5 was formed by applying the coating fluid by spin coating in an environment having the spectrum shown in Fig. 4 and heating the applied coating fluid in the environment shown in Fig. 3.

The voltage, efficiency, and chromaticity of the organic electroluminescence element obtained are shown in Table 5, and the working lives thereof are shown in Table 6.

[Table 5]

**Table 5**

| | Solvent | Film formation environment for luminescent layer | Voltage at 1000 cd/m² (V) | Current efficiency at 1000 cd/m² (cd/A) | CIE chromaticity coordinates |
|---|---|---|---|---|---|
| Example 2 | 1,2-DCE | yellow | 7.6 | 4.9 | (0.14, 0.17) |
| Comparative Example 2 | 1,2-DCE | Fluorescent lamp | 8.5 | 3.5 | (0.14, 0.18) |

[Table 6]

**Table 6**

| | Solvent | Film formation environment for luminescent layer | 70% luminance life in voltage application at 20 mA/cm² (h) | Initial luminance (cd/m²) | Converted life at 1,000 cd/m² (h) |
|---|---|---|---|---|---|
| Example 2 | 1,2-DCE | yellow | 95 | 2619 | 537 |
| Comparative Example 2 | 1,2-DCE | Fluorescent lamp | 70 | 1894 | 221 |

It can be seen from Table 5 and Table 6 that the organic electroluminescence element according to the invention combines a high efficiency and a long life.

### (EXAMPLE 3)

An organic electroluminescence element was produced in the same manner as in Example 1, except that a luminescent layer 5 having a thickness of 60 nm was formed by preparing a coating fluid for luminescent-layer formation containing compounds (C1), (C2), and (D1) and subjecting the coating fluid to application by spin coating and to heating under the following conditions in an environment having the spectrum shown in Fig. 3.

### <Coating Fluid for Luminescent-Layer Formation>

Solvent cyclohexylbenzene (CHB)
Concentrations of coating fluid
   C1: 1.25 wt%
   C2: 3.75 wt%
   D1: 0.50 wt%

### <Conditions for Forming Luminescent Layer 5>

| | |
|---|---|
| Spinner rotation speed | 1,500 rpm |
| Spinner rotation period | 120 sec |
| Spin coating atmosphere | in nitrogen |
| Heating conditions | 130°C; 1 hr; in nitrogen |

The voltage, efficiency, and chromaticity of the organic electroluminescence element obtained are shown in Table 7, and the working lives thereof are shown in Table 8.

### (COMPARATIVE EXAMPLE 3)

An organic electroluminescence element was produced in the same manner as in Example 3, except that a luminescent layer 5 was formed by applying the coating fluid by spin coating in an environment having the spectrum shown in Fig. 4 and heating the applied coating fluid in the environment shown in Fig. 3.

The voltage, efficiency, and chromaticity of the organic electroluminescence element obtained are shown in Table 7, and the working lives thereof are shown in Table 8.

[Table 7]

**Table 7**

| | Solvent | Film formation environment for luminescent layer | Voltage at 1000 cd/m² M | Current efficiency at 1000 cd/m² (cd/A) | CIE chromaticity coordinates |
|---|---|---|---|---|---|
| Example 3 | CHB | yellow | 8.2 | 36.1 | (0.33, 0.62) |
| Comparative Example 3 | CHB | fluorescent lamp | 8.6 | 29.0 | (0.34, 0.62) |

[Table 8]

**Table 8**

| | Solvent | Film formation environment for luminescent layer | 80% luminance life in voltage application at 20 mA/cm² (h) | Initial luminance (cd/m²) | Converted life at 1,000 cd/m² (h) |
|---|---|---|---|---|---|
| Example 3 | CHB | yellow | 105 | 6205 | 2806 |
| Comparative Example 3 | CHB | Fluorescent lamp | 38 | 5354 | 779 |

It can be seen from Table 7 and Table 8 that the organic electroluminescence element according to the invention combines a high efficiency and a long life.

### (EXAMPLE 4)

An organic electroluminescence element was produced in the same manner as in Example 1, except that a luminescent layer 5 having a thickness of 45 nm was formed by preparing a coating fluid for luminescent-layer formation containing compounds (C3) and (D2) and subjecting the coating fluid to application by spin coating and to heating under the following conditions in an environment having the spectrum shown in Fig. 3.

### <Coating Fluid for Luminescent-Layer Formation>

Solvent cyclohexylbenzene (CHB)
Concentrations of coating fluid
   C3: 3.10 wt%
   D2: 0.31 wt%

### <Conditions for Forming Luminescent Layer 5>

| | |
|---|---|
| Spinner rotation speed | 1,200 rpm |
| Spinner rotation period | 120 sec |
| Spin coating atmosphere | in nitrogen |
| Heating conditions | 130°C; 1 hr; in nitrogen |

The voltage, efficiency, and chromaticity of the organic electroluminescence element obtained are shown in Table 9, and the working lives thereof are shown in Table 10.

### (COMPARATIVE EXAMPLE 4)

An organic electroluminescence element was produced in the same manner as in Example 4, except that a luminescent layer 5 was formed by applying the coating fluid by spin coating in an environment having the spectrum shown in Fig. 4 and heating the applied coating fluid in the environment shown in Fig.3.

The voltage, efficiency, and chromaticity of the organic electroluminescence element obtained are shown in Table 9, and the working lives thereof are shown in Table 10.

[Table 9]

**Table 9**

| | Solvent | Film formation environment for luminescent layer | Voltage at 1000 cd/m² (V) | Current efficiency at 1000 cd/m² (cd/A) | CIE chromaticity coordinates |
|---|---|---|---|---|---|
| Example 4 | CHB | yellow | 7.7 | 4.8 | (0.14, 0.17) |
| Comparative Example 4 | CHB | Fluorescent lamp | 7.7 | 4.6 | (0.14, 0.16) |

[Table 10]

**Table 10**

| | Solvent | Film formation environment for luminescent layer | 80% luminance life in voltage application at 20 mA/cm² (h) | Initial luminance (cd/m²) | Converted life at 1,000 cd/m² (h) |
|---|---|---|---|---|---|
| Example 4 | CHB | yellow | 90 | 2395 | 434 |
| Comparative Example 4 | CHB | fluorescent lamp | 58 | 2279 | 255 |

It can be seen from Table 9 and Table 10 that the organic electroluminescence element according to the invention combines a high efficiency and a long life.

### (EXAMPLE 5)

An organic electroluminescence element was produced in the same manner as in Example 1, except that a luminescent layer 5 having a thickness of 60 nm was formed by preparing a coating fluid for luminescent-layer formation containing arylamine compound (C4) and compounds (D3) and (D1) respectively having the structures shown below and subjecting the coating fluid to application by spin coating and to heating under the following conditions in an environment having the spectrum shown in Fig. 3.

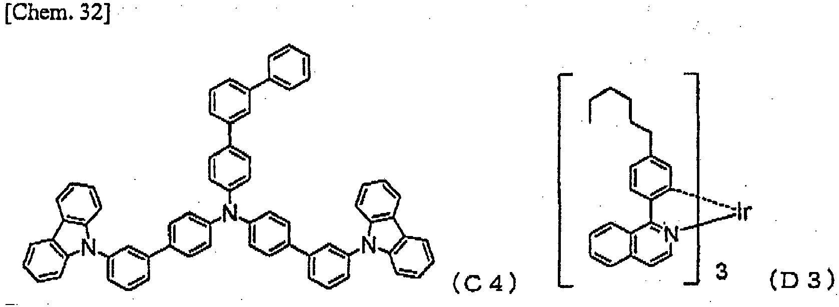

### <Coating Fluid for Luminescent-Layer Formation>

Solvent cyclohexylbenzene (CHB)
Concentrations of coating fluid
   C4: 5.00 wt%
   D1: 0.25 wt%
   D3: 0.35 wt%

### <Conditions for Forming Luminescent Layer 5>

| | |
|---|---|
| Spinner rotation speed | 1,500 rpm |
| Spinner rotation period | 120 sec |
| Spin coating atmosphere | in nitrogen |
| Heating conditions | 130°C; 1 hr; in nitrogen |

The voltage, efficiency, and chromaticity of the organic electroluminescence element obtained are shown in Table 11, and the working lives thereof are shown in Table 12.

### (COMPARATIVE EXAMPLE 5)

An organic electroluminescence element was produced in the same manner as in Example 5, except that a luminescent layer 5 was formed by conducting the spin coating and heating in an environment having the spectrum shown in Fig. 4.

The voltage, efficiency, and chromaticity of the organic electroluminescence element obtained are shown in Table 11, and the working lives thereof are shown in Table 12.

[Table 11]

**Table 11**

| | Solvent | Film formation environment for luminescent layer | Voltage at 1000cd/m² (V) | Current efficiency at 1000 cd/m² (cd/A) | CIE chromaticity coordinates |
|---|---|---|---|---|---|
| Example 5 | CHB | yellow | 11.6 | 7.2 | (0.67, 0.33) |
| Comparative Example 5 | CHB | fluorescent lamp | 12.3 | 6.3 | (0.68, 0.32) |

[Table 12]

**Table 12**

| | Solvent | Film formation environment for luminescent layer | Half-luminance life (h) | Initial luminance (cd/m²) | Converted life at 1,000 cd/m² (h) |
|---|---|---|---|---|---|
| Example 5 | CHB | yellow | 500 | 5000 | 9060 |
| Comparative Example 5 | CHB | fluorescent lamp | 500 | 3000 | 3612 |

It can be seen from Table 11 and Table 12 that the organic electroluminescence element of the invention has a high efficiency and a long working life.

This application is based on a Japanese patent application filed on March 13, 2009 (Application No. 2009-061668), the contents thereof being incorporated herein by reference.

### Industrial Applicability

The method of invention is suitable for use in various fields in which organic electroluminescence elements are used, for example, in the fields of flat panel displays (e.g., displays for OA computers and wall-mounted TV receivers), light sources taking advantage of the feature of a surface light emitter (e.g., the light source of a copier and the backlight of a liquid-crystal display or instrument), display panels, marker lights, and the like.

### Description of the Reference Numerals

- 1: Substrate
- 2: Anode
- 3: Hole injection layer
- 4: Hole transport layer
- 5: Luminescent layer
- 6: Hole blocking layer
- 7: Electron transport layer
- 8: Electron injection layer
- 9: Cathode
- 10: Sample layer

## Claims

1. A process for producing an organic electroluminescence element comprising a first electrode (2,9), a second electrode (2,9) formed so as to be opposed to the first electrode (2,9), and a luminescent layer (5,10) disposed between the first electrode (2,9) and the second electrode (2,9),
wherein
the luminescent layer (5,10) is a layer comprising an arylamine compound, **characterised in that** the luminescent layer (5,10) is formed by a wet film formation in an environment shielded from light having a wavelength shorter than 500 nm.

2. The process for producing an organic electroluminescence element according to claim 1, wherein the method of wet film formation comprises a wet application step and a drying step, and the drying step is conducted in an environment shielded from light having a wavelength shorter than 500 nm.

3. The process for producing an organic electroluminescence element according to claim 1 or 2, wherein the arylamine compound is a compound represented by the following formula (1): 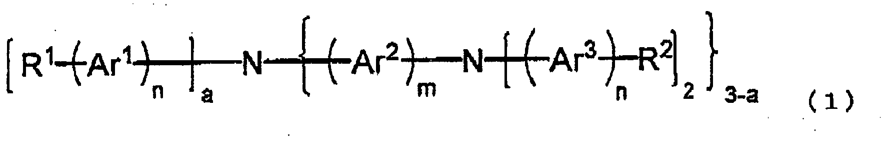 wherein
Ar¹ to Ar³ each independently represent an aromatic ring which has 6-30 carbon atoms and may have a substituent,
R¹ and R² each independently represent a hydrogen atom or an aromatic ring which has 5-30 carbon atoms and may have a substituent,
R¹ and R² may have a crosslinkable group as a substituent possessed by the aromatic rings,
n and m each independently represent an integer of 1-3, and a represents an integer of 0-3.

## Patentansprüche

1. Ein Verfahren zur Herstellung eines organischen elektrolumineszenten Elements, umfassend eine erste Elektrode (2,9), eine zweite Elektrode (2,9), die so gebildet ist, dass sie sich gegenüber der ersten Elektrode (2,9) befindet, und eine lumineszente Schicht (5,10), die zwischen der ersten Elektrode (2,9) und der zweiten Elektrode (2,9) angeordnet ist,
wobei
die lumineszente Schicht (5,10) eine Schicht ist, die eine Arylaminverbindung umfasst, **dadurch gekennzeichnet, dass** die lumineszente Schicht (5,10) durch eine Nassfilmbildung in einer Umgebung, die gegen Licht mit einer Wellenlänge, die kürzer als 500 nm ist, abgeschirmt ist, gebildet wird.

2. Das Verfahren zur Herstellung eines organischen elektrolumineszenten Elements gemäß Anspruch 1, wobei das Verfahren der Nassfilmbildung einen Nassauftragsschritt und einen Trockenschritt umfasst und der Trockenschritt in einer Umgebung, die gegen Licht mit einer Wellenlänge, die kürzer als 500 nm ist, abgeschirmt ist, durchgeführt wird.

3. Das Verfahren zur Herstellung eines organischen elektrolumineszenten Elements gemäß Anspruch 1 oder 2, wobei die Arylaminverbindung eine Verbindung, dargestellt durch die folgende Formel (1): 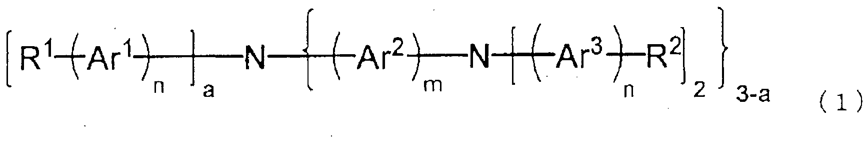 ist,
wobei
Ar¹ bis Ar³ jeweils unabhängig voneinander für einen aromatischen Ring stehen, der 6-30 Kohlenstoffatome aufweist und einen Substituenten aufweisen kann,
R¹ und R² jeweils unabhängig voneinander für ein Wasserstoffatom oder einen aromatischen Ring stehen, der 5-30 Kohlenstoffatome aufweist und einen Substituenten aufweisen kann,
R¹ und R² in den aromatischen Ringen einen vernetzbaren Rest als einen Substituenten aufweisen können,
n und m jeweils unabhängig voneinander für eine ganze Zahl von 1-3 stehen und a für eine ganze Zahl von 0-3 steht.

## Revendications

1. Procédé de production d'un élément d'électroluminescence organique comprenant une première électrode (2, 9), une seconde électrode (2, 9) formée afin d'être opposée à la première électrode (2, 9), et une couche luminescente (5, 10) disposée entre la première électrode (2, 9) et la seconde électrode (2, 9),
dans lequel
la couche luminescente (5, 10) est une couche comprenant un composé d'arylamine, **caractérisé en ce que** la couche luminescente (5, 10) est formée par une formation de film humide dans un environnement protégé par écran d'une lumière ayant une longueur d'onde plus courte que 500 nm.

2. Procédé de production d'un élément d'électroluminescence organique selon la revendication 1, dans lequel le procédé de formation de film humide comprend une étape d'application humide et une étape de séchage, et l'étape de séchage est réalisée dans un environnement protégé par écran d'une lumière ayant une longueur d'onde plus courte que 500 nm.

3. Procédé de production d'un élément d'électroluminescence organique selon la revendication 1 ou 2, dans lequel le composé d'arylamine est un composé représenté par la formule (1) suivante : 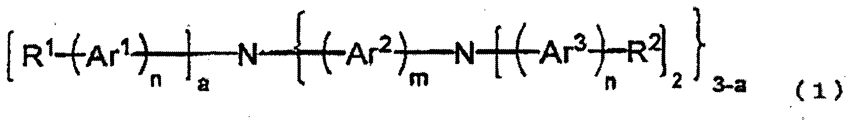 où
Ar¹ à Ar³ représentent chacun indépendamment un cycle aromatique qui présente 6-30 atomes de carbone et peut présenter un substituant,
R¹ et R² représentent chacun indépendamment un atome d'hydrogène ou un cycle aromatique qui présente 5-30 atomes de carbone et peut présenter un substituant,
R¹ et R² peuvent présenter un groupe réticulable comme un substituant possédé par les cycles aromatiques,
n et m représentent chacun indépendamment un nombre entier de 1-3, et a représente un nombre entier de 0-3.
